# EUROPEAN PATENT APPLICATION

(11) **EP 4 746 649 A1**
(43) Date of publication of application: **20.05.2026**
(21) Application number: 24850948.1
(22) Date of filing: 02.08.2024
(51) Int. Cl.: H10K 30/40

(54) **PEROVSKITE BATTERY AND PREPARATION METHOD THEREFOR, AND ELECTRIC DEVICE**

(30) Priority: 04.08.2023 CN 202310980482; 22.04.2024 WO PCT/CN2024/089143
(71) Applicant: Contemporary Amperex Technology Co., Limited, Ningde, Fujian 352100 (CN)
(72) Inventor: ZHOU, Hongmei, Ningde, Fujian 352100 (CN); ZHOU, Zichun, Ningde, Fujian 352100 (CN); LIN, Weile, Ningde, Fujian 352100 (CN); WANG, Shidan, Ningde, Fujian 352100 (CN); OUYANG, Chuying, Ningde, Fujian 352100 (CN)
(74) Representative: Lorenz Seidler Gossel Part. mbB
(86) International application number: PCT/CN2024/109663
(87) International publication number: WO 2025/031303

(57) **Abstract**

A perovskite battery and a preparation method therefor, and an electric device. The perovskite battery comprises a first electrode layer, a hole transport layer, a perovskite layer, and a second electrode layer which are sequentially stacked, wherein the surface roughness of the hole transport layer is Ra₁, and Ra₁ is less than or equal to 10 nm.

## Description

### CROSS-REFERENCE TO RELATED APPLICATIONS

The present application is proposed based on and claims priority to Chinese Patent Application No. 202310980482.0 filed on August 04, 2023 and PCT Patent Application No. PCT/CN2024/089143 filed on April 22, 2024, which are incorporated herein by reference in their entireties.

### TECHNICAL FIELD

The present application relates to the field of solar cell technologies, and in particular, to a perovskite cell and a method for preparing the same, and a power consuming apparatus.

### BACKGROUND

Descriptions herein merely provide background information related to the present application, but do not necessarily constitute the prior art.

Perovskite solar cells are apparatuses that convert solar energy into electric energy by using a photoelectric conversion mechanism of a perovskite crystal material, are current third-generation solar cells, have many advantages such as high photoelectric conversion efficiency, a simple manufacturing process, and low production costs, and are extensively researched in recent years. Notwithstanding, there is still a particular distance to the commercial large-scale application of perovskite cells, where how to improve the apparatus efficiency of the perovskite cells is one of key problems that need to be resolved urgently.

### SUMMARY

In view of the foregoing problem, the present application provides a perovskite cell and a method for preparing the same, and a power consuming apparatus. Apparatus efficiency of the perovskite cell can be improved by improving the perovskite cell.

According to a first aspect, the present application provides a perovskite cell, including a first electrode layer, a hole transport layer, a perovskite layer, and a second electrode layer stacked sequentially, where surface roughness of the hole transport layer is Ra₁, and Ra₁≤10 nanometers (nm).

In the foregoing perovskite cell provided in the present application, when the surface roughness Ra₁ of the hole transport layer is ≤ 10 nm, the flatness and smoothness of the film surface of the hole transport layer are relatively high. In this way, a contact gap between the hole transport layer and an interface of the perovskite layer disposed adjacent to the hole transport layer can be reduced, and the transport efficiency of hole carriers is improved, thereby improving the apparatus efficiency of the perovskite cell.

In some implementations, the surface roughness Ra₁ of the hole transport layer satisfies: Ra₁<3 nm.

In the foregoing perovskite cell provided in the present application, when the surface roughness Ra₁ of the hole transport layer is < 3 nm, the flatness and smoothness of the film surface of the hole transport layer are relatively high. In this way, a contact gap between the hole transport layer and an interface of the perovskite layer disposed adjacent to the hole transport layer can be reduced, and the transport efficiency of hole carriers is improved, thereby improving the apparatus efficiency of the perovskite cell.

In some implementations, the surface roughness Ra₁ of the hole transport layer satisfies: 0<Ra₁≤2 nm.

In some implementations, the surface roughness Ra₁ of the hole transport layer satisfies: 0<Ra₁≤1.5 nm.

The surface roughness of the hole transport layer falls within the foregoing range, helping to further reduce a contact gap between the hole transport layer and the perovskite layer, and further improve the transport efficiency of the hole carriers, thereby further improving the apparatus efficiency of the perovskite cell.

In some implementations, a quantity of pinholes per unit area of the hole transport layer is n₁, and 0 ≤ n₁ ≤ 2, optionally, 0 ≤ n₁ ≤ 1.

The quantity of pinholes per unit area of the hole transport layer falls within the foregoing range, helping to reduce a contact gap between the hole transport layer and an interface of the perovskite layer disposed adjacent to the hole transport layer (for example, a lower interface of the perovskite layer), to facilitate throughout-growth of the grains in the perovskite layer and transport of the hole carriers, thereby improving the apparatus efficiency of the perovskite cell.

In some implementations, the perovskite layer includes grains distributed throughout along a thickness direction of the perovskite layer;
optionally, an average size of the grains ranges from 600 nm to 800 nm, optionally, from 650 nm to 750 nm.

In the present application, the perovskite layer includes the grains distributed throughout along the thickness direction of the perovskite layer, helping to reduce stacking between the grains. In this way, the quantity of grain boundaries generated due to stacking between the grains can be reduced, the occurrence of non-radiative recombination at the grain boundaries can be reduced, the carrier transport efficiency can be improved, the ion migration can be suppressed, and the deep-level defects can be reduced, thereby improving the apparatus efficiency and stability of the perovskite cell.

In some implementations, surface roughness of the perovskite layer is Ra₂, and Ra₂<35 nm, optionally, Ra₂≤25 nm.

When the surface roughness Ra₂ of the perovskite layer is < 35 nm, the flatness and smoothness of the film surface of the perovskite layer are relatively high. In this way, a contact gap between the perovskite layer and an interface of a charge transport layer (the hole transport layer or the electron transport layer) disposed adjacent to the perovskite layer can be reduced, and the transport efficiency of carriers is improved, thereby improving the apparatus efficiency of the perovskite cell.

In some implementations, Ra₂<3 nm. When the surface roughness Ra₂ of the perovskite layer is < 3 nm, the flatness and smoothness of the film surface of the perovskite layer are relatively high. In this way, a contact gap between the perovskite layer and an interface of a charge transport layer (the hole transport layer or the electron transport layer) disposed adjacent to the perovskite layer can be reduced, and the transport efficiency of carriers is improved, thereby improving the apparatus efficiency of the perovskite cell.

In some implementations, 0<Ra₂≤1.5 nm.

In some implementations, a quantity of pinholes per unit area of the perovskite layer is n₂, and 0 ≤ n₂ ≤ 2, optionally, 0 ≤ n₂ ≤ 1.

The quantity of pinholes per unit area of the perovskite layer falls within the foregoing range, helping to improve compactness of the perovskite layer, reduce a leakage current, reduce a contact gap between the hole transport layer and an interface of a charge transport layer (the hole transport layer or the electron transport layer) disposed adjacent to the hole transport layer, improve carrier transport efficiency, and further improve the apparatus efficiency of the perovskite cell.

In some implementations, a mean surface potential difference of the perovskite layer satisfies: -10 volts (V)≤Raw Mean≤10V. In this way, the surface potential of the perovskite layer is relatively uniformly distributed, which means that the film quality of the perovskite layer is relatively high, to enable the perovskite cell to have relatively high efficiency.

In some implementations, a mean surface potential difference of the perovskite layer satisfies: - 3V≤Raw Mean≤5V.

In some implementations, the perovskite cell satisfies at least one of the following conditions:
(1) a thickness of the hole transport layer ranges from 10 nm to 30 nm, optionally, from 15 nm to 25 nm; and
(2) a thickness of the perovskite layer ranges from 700 nm to 1200 nm, optionally, from 800 nm to 1000 nm.

The thickness of the perovskite layer falls within the foregoing range, which helps to promote carrier transport and collection, thereby promoting improvement of the apparatus efficiency of the perovskite cell.

In some implementations, the perovskite cell satisfies at least one of the following conditions:
(1) the perovskite layer includes a compound ABX₃ or A₂CDX₆, where the A ion is a monocation, the B ion is a dication, the C ion is a monocation, the D ion is a trication, and the X ion is a monoanion; and
   optionally, the A ion includes one or more of an organic cation, Li⁺, Na⁺, K⁺, Rb⁺, and Cs⁺,
   optionally, where the organic cation includes at least one of methylammonium, ethylammonium, propylammonium, butylammonium, pentylammonium, hexylammonium, formamidinium, and imidazolium;
   optionally, the A ion includes one or more of an organic amine ion and Cs⁺;
   optionally, the B ion includes one or more of Pb²⁺, Sn₂⁺, Be²⁺, Mg²⁺, Ca²⁺, Sr²⁺, Ba²⁺, Zn₂⁺, Ge²⁺, Fe²⁺, Co²⁺, Cu²⁺, and Ni²⁺;
   optionally, the B ion includes one or two of Pb²⁺ and Sn₂⁺;
   optionally, the C ion includes one or more of Cs⁺, Ag⁺, K⁺, and Ru⁺;
   optionally, the D ion includes one or more of Bi³⁺, Ni³⁺, Fe³⁺, and Cu³⁺; and
   optionally, the X ion includes one or more of F⁻, Cl⁻, Br⁻, and I⁻;
   optionally, the X ion includes one or more of Cl⁻, Br⁻, and I⁻; and
   optionally, the perovskite layer includes a compound APb_{y}Sn_{1-y}X₃, and 0<y<1; and
(2) the perovskite cell further includes an electron transport layer, and the electron transport layer is disposed between the perovskite layer and the second electrode layer.

In some implementations, the first electrode layer includes a transparent conductive metal oxide.

In some implementations, the transparent conductive metal oxide includes one or more of fluorine-doped tin oxide, tin-doped indium oxide, aluminum-doped zinc oxide, boron-doped zinc oxide, indium zinc oxide, and tungsten-doped indium oxide.

In some implementations, the transparent conductive metal oxide includes one or two of fluorine-doped tin oxide and tin-doped indium oxide.

In some implementations, the first electrode layer includes fluorine-doped tin oxide, and a thickness of a conductive region of the first electrode layer ranges from 400 nm to 700 nm.

In some implementations, the first electrode layer includes tin-doped indium oxide, and a thickness of a conductive region of the first electrode layer ranges from 150 nm to 250 nm.

In some implementations, the perovskite cell further includes a buffer layer disposed between the first electrode layer and the hole transport layer. The buffer layer can reduce surface roughness of a surface in contact with the hole transport layer, and improve binding and adhesion between the first electrode layer and the hole transport layer.

In some implementations, a thickness of the buffer layer ranges from 1 nm to 100 nm.

According to a second aspect, the present application provides a method for preparing a perovskite cell, including:
preparing a hole transport layer on a first electrode layer, where surface roughness of the hole transport layer is Ra₁, and Ra₁≤10 nm; and
preparing a perovskite layer and a second electrode layer stacked sequentially on the hole transport layer, to obtain a perovskite cell.

In the perovskite cell prepared by using the foregoing method, the surface roughness Ra₁ of the hole transport layer is ≤ 10 nm. In this way, the flatness and smoothness of the film surface of the hole transport layer are relatively high. In this way, a contact gap between the hole transport layer and an interface of the perovskite layer disposed adjacent to the hole transport layer can be reduced, and the transport efficiency of hole carriers is improved, thereby improving the apparatus efficiency of the perovskite cell.

In some implementations, Ra₁<3 nm. In this way, the flatness and smoothness of the film surface of the hole transport layer are relatively high. In this way, a contact gap between the hole transport layer and an interface of the perovskite layer disposed adjacent to the hole transport layer can be reduced, and the transport efficiency of hole carriers is improved, thereby improving the apparatus efficiency of the perovskite cell.

In some implementations, the preparing a hole transport layer on a first electrode layer includes:
preparing the hole transport layer on the first electrode layer in a first vacuum flash-evaporation manner;
optionally, the preparing the hole transport layer in the first vacuum flash-evaporation manner includes:
coating the first electrode layer with a solution of a hole transport material, to form a wet film of the hole transport material; and
performing first vacuum flash-evaporation treatment on the wet film of the hole transport material, to flash-evaporate a solvent in the solution of the hole transport material, and form the hole transport layer;
optionally, the first vacuum flash-evaporation treatment is performed in an air atmosphere.

In the foregoing method for preparing a perovskite cell provided in the present application, the hole transport layer is prepared in the vacuum flash-evaporation manner. Because the vacuum flash-evaporation can rapidly extract and remove the solvent in the solution of the hole transport material, the process time can be greatly shortened.

In some implementations, the method satisfies at least one of the following conditions:
(1) a temperature of the first vacuum flash-evaporation treatment ranges from 15 degrees Celsius (°C) to 35°C;
(2) an extraction rate of the first vacuum flash-evaporation treatment ranges from 5 cubic meters/hour (m³/h) to 20 m³/h; and
(3) the hole transport material includes one or more of 2,2',7,7'-Tetrakis[N,N-bis(4-methoxyphenyl)amino]-9,9'-spirobifluorene, poly(triaryl amine), poly(3,4-ethylenedioxythiophene):polystyrene sulfonate, poly[bis(4-phenyl)(2,4,6-trimethylphenyl)amine], 2,2',7,7'-Tetrakis[N,N-bis(4-methoxyphenyl)amino]-9,9'-spirobifluorene, poly-3-hexylthiophene, triptycene-cored triphenylamine, 3,4-ethylenedioxythiophene-methoxytriphenylamine, and N-(4-aniline)carbazole-spirobifluorene,
optionally, poly(3,4-ethylenedioxythiophene):polystyrene sulfonate.

The temperature of the first vacuum flash-evaporation treatment falls within the foregoing range, helping to reduce generation of fine cracks or wrinkles inside and on the surface of the film of the hole transport layer, reduce the surface roughness of the film, and improve the surface flatness of the film, thereby improving the apparatus efficiency of the perovskite cell.

In some implementations, the perovskite layer is prepared in a second vacuum flash-evaporation manner.

In some implementations, the preparing the perovskite layer in the second vacuum flash-evaporation manner includes:
coating the hole transport layer with a perovskite precursor solution, to form a perovskite wet film;
performing second vacuum flash-evaporation treatment on the perovskite wet film, to flash-evaporate a solvent in the perovskite precursor solution, and form a perovskite intermediate phase film; and
performing annealing treatment on the perovskite intermediate phase film, to form the perovskite layer;
optionally, the second vacuum flash-evaporation treatment is performed in a nitrogen atmosphere.

The preparing the perovskite layer in the vacuum flash-evaporation manner can effectively regulate the internal grain growth and the surface morphology of the perovskite layer, improve the film quality of the perovskite layer, and further improve the apparatus efficiency of the perovskite cell.

In some implementations, the method satisfies at least one of the following conditions:
(1) a temperature of the second vacuum flash-evaporation treatment ranges from 15°C to 35°C, optionally, from 18°C to 22°C;
(2) an extraction rate of the second vacuum flash-evaporation treatment ranges from 10 m³/h to 30 m³/h; optionally, from 15 m³/h to 30 m³/h;
(3) a temperature of the annealing treatment ranges from 70°C to 130°C, optionally, from 100°C to 130°C;
(4) an annealing time of the annealing treatment ranges from 5 minutes (min) to 30 min, optionally, from 10 min to 20 min; and
(5) the perovskite precursor solution includes a compound ABX₃ or A₂CDX₆, where the A ion is a monocation, the B ion is a dication, the C ion is a monocation, the D ion is a trication, and the X ion is a monoanion; and

optionally, the A ion includes one or more of an organic cation, Li⁺, Na⁺, K⁺, Rb⁺, and Cs⁺,
optionally, where the organic cation includes at least one of methylammonium, ethylammonium, propylammonium, butylammonium, pentylammonium, hexylammonium, formamidinium, and imidazolium;
optionally, the A ion includes one or more of an organic amine ion and Cs⁺;
optionally, the B ion includes one or more of Pb²⁺, Sn₂⁺, Be²⁺, Mg²⁺, Ca²⁺, Sr²⁺, Ba²⁺, Zn₂⁺, Ge²⁺, Fe²⁺, Co²⁺, Cu²⁺, and Ni²⁺;
optionally, the B ion includes one or two of Pb²⁺ and Sn₂⁺;
optionally, the C ion includes one or more of Cs⁺, Ag⁺, K⁺, and Ru⁺;
optionally, the D ion includes one or more of Bi³⁺, Ni³⁺, Fe³⁺, and Cu³⁺; and
optionally, the X ion includes one or more of F⁻, Cl⁻, Br⁻, and I⁻;
optionally, the X ion includes one or more of Cl⁻, Br⁻, and I⁻; and
optionally, the perovskite precursor solution includes a compound APb_{y}Sn_{1-y}X₃, and 0<y<1.

The preparing the perovskite layer in the vacuum flash-evaporation manner can quickly extract the solvent in the perovskite precursor solution, reduce a nucleation and crystallization speed of the perovskite, and increase the average size of the grains in the perovskite layer; and help to promote throughout-growth of the grains along the thickness direction of the perovskite layer, improve consistency and uniformity of the grain growth, reduce stacking between the grains. In this way, the quantity of grain boundaries between the grains can be reduced, the occurrence of non-radiative recombination at the grain boundaries can be reduced, the carrier transport efficiency can be improved, the ion migration can be suppressed, and the deep-level defects can be reduced, thereby improving the apparatus efficiency and stability of the perovskite cell.

In some implementations, the method further includes: preparing an electron transport layer between the perovskite layer and the second electrode layer.

In some implementations, the method may further include: preparing a buffer layer between the first electrode layer and the hole transport layer.

In some examples, a method for preparing the buffer layer includes one of spin-coating, blade coating, evaporation, printing, spraying, spray pyrolysis, and slot die coating.

According to a third aspect, the present application provides a stack cell, including the perovskite cell according to the first aspect of the present application or a perovskite cell prepared by using the method according to the second aspect of the present application.

According to a fourth aspect, the present application provides a photovoltaic module, including at least one of the perovskite cell according to the first aspect of the present application, a perovskite cell prepared by using the method according to the second aspect of the present application, and the stack cell according to the third aspect of the present application.

According to a fifth aspect, the present application provides a power consuming apparatus, including at least one of the perovskite cell according to the first aspect of the present application, a perovskite cell prepared by using the method according to the second aspect of the present application, the stack cell according to the third aspect of the present application, and the photovoltaic module according to the fourth aspect of the present application.

Details of one or more examples of the present application are provided in the accompanying drawings and descriptions below. Other features, objects, and advantages of the present application will become apparent from the specification, the drawings, and the claims.

### BRIEF DESCRIPTION OF THE DRAWINGS

In order to provide a clearer explanation of the technical solution of the examples of the present application, a brief introduction will be given to the accompanying drawings required in the examples of the present application. It is evident that the accompanying drawings described below are only some examples of the present application. For persons of ordinary skill in the art, other accompanying drawings can be obtained based on the drawings without any creative effort. In the accompanying drawings:
FIG. 1 is a schematic diagram of a perovskite cell according to an implementation of the present application.
FIG. 2 is a schematic diagram of a perovskite cell according to an implementation of the present application.
FIG. 3 is a schematic diagram of a perovskite cell according to an implementation of the present application.
FIG. 4 is a schematic diagram of a device for performing vacuum flash-evaporation according to an implementation of the present application.
FIG. 5 is a surface topography diagram of hole transport layers of perovskite cells of Example 1 (FIG. (b)) and Comparative Example 1 (FIG. (a)).
FIG. 6 is cross-sectional topography diagram of the hole transport layer of the perovskite cell in Example 1 at different magnifications.
FIG. 7 is a surface topography diagram of perovskite layers of perovskite cells of Example 1 (FIG. (b)) and Comparative Example 2 (FIG. (a)).
FIG. 8 is cross-sectional topography diagram of the perovskite layer of the perovskite cell in Example 18 at different magnifications.
FIG. 9 is cross-sectional topography diagram of the perovskite layer of the perovskite cell in Example 1 at different magnifications.
FIG. 10 is a schematic diagram of a power consuming apparatus using a perovskite cell as a power supply according to an implementation of the present application.

Reference numerals: 10, substrate layer; 20, first electrode layer; 30, hole transport layer; 40, perovskite layer; 50, electron transport layer; and 60, second electrode layer.

### DETAILED DESCRIPTION

Some implementations of a perovskite cell and a method for preparing the same, and a power consuming apparatus are disclosed in detail below and appropriately described with reference to the accompanying drawings. However, there will be cases where unnecessary detailed descriptions are omitted. For example, there are cases in which detailed explanations of well-known matters and repeated explanations of actually the same structure are omitted. Thus, the following illustrations do not become unnecessarily lengthy, which facilitates understanding by those skilled in the art. In addition, the accompanying drawings and subsequent descriptions are provided for those skilled in the art to fully understand the present application, and are not intended to limit the subject matter recited in the claims.

A "range" disclosed in the present application is defined in a form of a lower limit and an upper limit. A given range is defined by selecting a lower limit and an upper limit, and the selected lower limit and upper limit define a boundary of the specific range. The range defined in this manner may include or exclude end values, and may be arbitrarily combined, that is, any lower limit can be combined with any upper limit to form a range. For example, if ranges of 60 to 120 and 80 to 110 are listed for a particular parameter, it is to be understood that ranges of 60 to 110 and 80 to 120 are also expected. In addition, if the minimum range values 1 and 2 are listed, and if the maximum range values 3, 4, and 5 are listed, the following ranges can all be expected: 1 to 3, 1 to 4, 1 to 5, 2 to 3, 2 to 4, and 2 to 5. In the present application, unless stated otherwise, the numerical range "a to b" represents an abbreviated representation of any combination of real numbers between a to b, where both a and b are real numbers. For example, the numerical range "0 to 5" represents that all real numbers between 0 and 5 are listed herein, and "0 to 5" is merely the abbreviated representation of the combination of these numbers. In addition, when a parameter is expressed as an integer ≥ 2, it is equivalent to disclosing that the parameter is, for example, an integer of 2, 3, 4, 5, 6, 7, 8, 9, 10, 11, 12, etc. For example, when a parameter is expressed as an integer selected from "2-10", it is equivalent to lists integers 2, 3, 4, 5, 6, 7, 8, 9, and 10.

Unless otherwise specified, all the implementations and optional implementations of the present application can be combined with each other form new technical solutions.

If there is no special explanation, all steps of the present application may be performed sequentially or randomly, and preferably sequentially. For example, the method including steps (a) and (b) indicates that the method may include steps (a) and (b) performed sequentially, or the method may include steps (b) and (a) performed sequentially. For example, reference to "the method may further include step (c)" indicates that step (c) may be added to the method in any order, e.g., the method may include steps (a), (b) and (c), or steps (a), (c) and (b), or steps (c), (a) and (b), or the like.

In the present application, unless otherwise specified, A (such as B) indicates that B is a non-limiting example of A. It can be understood that A is not limited to B.

The terms "plurality", "multiple", and the like in the present application mean greater than 2 or equal to 2 in number, unless otherwise limited. For example, "one or more" means one or more than or equal to two.

In the present application, in the "first aspect", "second aspect", "third aspect", "fourth aspect", and the like, the terms "first", "second", "third", "fourth", and the like are only used for descriptive purposes, and cannot be understood as indicating or implying relative importance or quantity, nor implicitly indicating the importance or quantity of the indicated technical features. Moreover, the "first", "second", "third", "fourth" and the like are merely used for the purpose of non-exhaustive description, and should not be understood as constituting a closed limitation on the quantity.

In a perovskite cell, especially, a narrow-bandgap tin-lead perovskite cell, many small cracks or wrinkles usually exist on a film surface of a hole transport layer prepared by using a conventional method (coating+ annealing). Consequently, the film surface is not flat, and there is a large contact gap between the hole transport layer and a perovskite layer, thereby affecting transport of hole carriers, and further affecting apparatus efficiency of the perovskite cell.

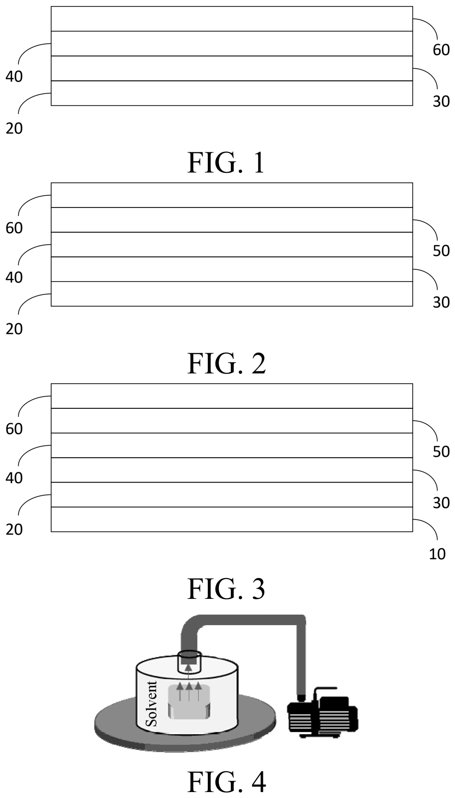

Based on this, according to a first aspect, the present application provides a perovskite cell, as shown in FIG. 1, including a first electrode layer 20, a hole transport layer 30, a perovskite layer 40, and a second electrode layer 60 stacked sequentially, where surface roughness of the hole transport layer 30 is Ra₁, and Ra₁≤10 nm.

In the foregoing perovskite cell provided in the present application, when the surface roughness Ra₁ of the hole transport layer is ≤ 10 nm, the flatness and smoothness of the film surface of the hole transport layer are relatively high. In this way, a contact gap between the hole transport layer and an interface of the perovskite layer disposed adjacent to the hole transport layer can be reduced, and the transport efficiency of hole carriers is improved, thereby improving the apparatus efficiency of the perovskite cell.

For example, Ra₁ may be 10 nm, 9 nm, 8 nm, 7 nm, 6 nm, 5 nm, 4 nm, 3 nm, 2 nm, or 1 nm or fall within a range formed by any values described above. In this way, the flatness and smoothness of the film surface of the hole transport layer are higher, and the device efficiency of the perovskite cell is also higher.

In some implementations, the surface roughness Ra₁ of the hole transport layer satisfies: Ra₁<3 nm. For example, Ra₁ may be 2.9 nm, 2.7 nm, 2.5 nm, 2.3 nm, 2.1 nm, 1.9 nm, 1.7 nm, 1.5 nm, 1.3 nm, 1.1 nm, 0.9 nm, 0.7 nm, 0.5 nm, 0.3 nm, or 0.1 nm or fall within a range formed by any values described above.

When the surface roughness Ra₁ of the hole transport layer is < 3 nm, the flatness and smoothness of the film surface of the hole transport layer are relatively high. In this way, a contact gap between the hole transport layer and an interface of the perovskite layer disposed adjacent to the hole transport layer can be reduced, and the transport efficiency of hole carriers is improved, thereby improving the apparatus efficiency of the perovskite cell.

In some implementations, the surface roughness Ra₁ of the hole transport layer satisfies: 0<Ra₁≤2 nm. In this way, the flatness and smoothness of the film surface of the hole transport layer are higher, and the device efficiency of the perovskite cell is also higher.

In some implementations, the surface roughness Ra₁ of the hole transport layer satisfies: 0<Ra₁≤1.5 nm. For example, Ra₁ may be 0.01 nm, 0.05 nm, 0.1 nm, 0.3 nm, 0.5 nm, 0.7 nm, 0.9 nm, 1.1 nm, 1.3 nm, 1.5 nm, 1.7 nm, 1.9 nm, or 2 nm or fall within a range formed by any values described above.

It may be understood that, the surface roughness of the hole transport layer being Ra₁ may be that surface roughness of the hole transport layer on a side that is relatively far away from the first electrode layer and relatively close to the perovskite layer is Ra₁.

The surface roughness of the hole transport layer falls within the foregoing range, helping to further reduce a contact gap between the hole transport layer and the perovskite layer, and further improve the transport efficiency of the hole carriers, thereby further improving the apparatus efficiency of the perovskite cell.

In some implementations, a quantity of pinholes per unit area of the hole transport layer is n₁, and 0 ≤ n₁ ≤ 2. Optionally, a quantity of pinholes per unit area of the hole transport layer is 0 ≤ n₁ ≤ 1.

The quantity of pinholes per unit area of the hole transport layer falls within the foregoing range, helping to reduce a contact gap between the hole transport layer and an interface of the perovskite layer disposed adjacent to the hole transport layer (for example, a lower interface of the perovskite layer), to facilitate throughout-growth of the grains in the perovskite layer and transport of the hole carriers, thereby improving the apparatus efficiency of the perovskite cell.

In some implementations, a thickness of the hole transport layer ranges from 10 nm to 30 nm. For example, the thickness of the hole transport layer may be 10 nm, 15 nm, 20 nm, 25 nm, or 30 nm or fall within a range formed by any values described above. Optionally, a thickness of the hole transport layer ranges from 15 nm to 25 nm.

The thickness of the hole transport layer falls within the foregoing range, which helps to promote hole carrier transport and collection, thereby promoting improvement of the apparatus efficiency of the perovskite cell.

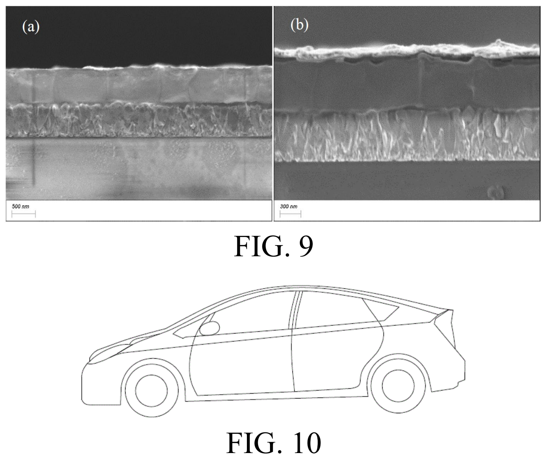

In some implementations, the perovskite layer includes grains distributed throughout along a thickness direction of the perovskite layer (referring to FIG. 9).

It may be understood that, the perovskite layer including the grains distributed throughout along the thickness direction of the perovskite layer means that in the grains included in the perovskite layer, there are grains that are grown and distributed throughout the perovskite layer along the stacking direction of the layers of the perovskite cell. That is, an axial direction of the grain is approximately perpendicular to a film surface of the perovskite layer, and two ends of the grain are respectively close to an upper interface and a lower interface of the perovskite layer.

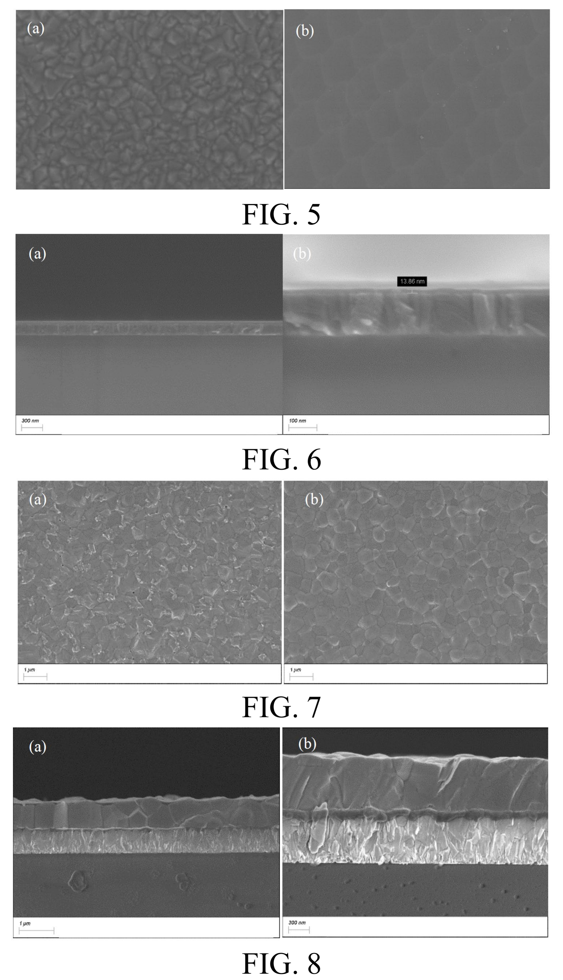

In a conventional perovskite layer, the size of the grains is usually relatively small. Therefore, the grains may be stacked on each other and distributed (referring to FIG. 8). Such a stack on each other of the grains generates a large quantity of grain boundaries. Non-radiative recombination easily occurs at these interfaces, to further affect carrier transport, promote ion migration, and introduce deep-level defects, thereby causing reduction of apparatus efficiency and stability of the perovskite cell. However, in the present application, the perovskite layer includes the grains distributed throughout along the thickness direction of the perovskite layer, helping to reduce stacking between the grains. In this way, the quantity of grain boundaries generated due to stacking between the grains can be reduced, the occurrence of non-radiative recombination at the grain boundaries can be reduced, the carrier transport efficiency can be improved, the ion migration can be suppressed, and the deep-level defects can be reduced, thereby improving the apparatus efficiency and stability of the perovskite cell.

In some implementations, an average size of the grains ranges from 600 nm to 800 nm. For example, the average size of the grains may be 600 nm, 620 nm, 640 nm, 660 nm, 680 nm, 700 nm, 720 nm, 740 nm, 760 nm, 780 nm, or 800 nm or fall within a range formed by any values described above. Optionally, an average size of the grains ranges from 650 nm to 750 nm.

The average size of the grains has well-known meanings in the art, and can be measured by using methods known in the art. For example, measurement may be performed by using a scanning electron microscope. During the measurement, the grains may be observed and measured on a unit area of the perovskite layer. For example, at a magnification of 30K, a region having a unit area (for example, 2.5 µm × 2.5 µm) of the surface of the perovskite layer is scanned, maximum radii of several (for example, 10) grains are measured in the region, and the average size of the grains may be obtained by averaging.

The average size of the grains falls within the foregoing range, which helps to reduce the quantity of grains and the quantity of grain boundaries on the unit area of the perovskite layer, thereby reducing the occurrence of non-radiative recombination at the grain boundaries, improving the carrier transport efficiency, suppressing the ion migration, and reducing the deep-level defects. Therefore, the apparatus efficiency and stability of the perovskite cell can be further improved.

In some implementations, surface roughness of the perovskite layer is Ra₂, and Ra₂<35 nm. For example, Ra₂ may be 0.01 nm, 0.05 nm, 0.1 nm, 0.3 nm, 0.5 nm, 0.7 nm, 0.9 nm, 1.1 nm, 1.3 nm, 1.5 nm, 1.7 nm, 1.9 nm, 2.1 nm, 2.3 nm, 2.5 nm, 2.7 nm, 2.9 nm, 3 nm, 5 nm, 7 nm, 10 nm, 13 nm, 15 nm, 17 nm, 20 nm, 21 nm, 22 nm, 23 nm, 24 nm, 25 nm, 26 nm, 27 nm, 28 nm, 29 nm, 30 nm, 32 nm, or 35 nm or fall within a range formed by any values described above.

It may be understood that, the surface roughness of the perovskite layer being Ra₂ may be that surface roughness of the perovskite layer on a side that is relatively far away from the hole transport layer and relatively close to the second electrode layer is Ra₂.

When the surface roughness Ra₂ of the perovskite layer is < 35 nm, the flatness and smoothness of the film surface of the perovskite layer are relatively high. In this way, a contact gap between the perovskite layer and an interface of a charge transport layer (the hole transport layer or the electron transport layer) disposed adjacent to the perovskite layer can be reduced, and the transport efficiency of carriers is improved, thereby improving the apparatus efficiency of the perovskite cell.

In some implementations, Ra₂≤25 nm. In this way, the flatness and smoothness of the film surface of the perovskite layer are higher, and the device efficiency of the perovskite cell is also higher.

In some implementations, Ra₂<3 nm. When the surface roughness Ra₂ of the perovskite layer is < 3 nm, the flatness and smoothness of the film surface of the perovskite layer are relatively high. In this way, a contact gap between the perovskite layer and an interface of a charge transport layer (the hole transport layer or the electron transport layer) disposed adjacent to the perovskite layer can be reduced, and the transport efficiency of carriers is improved, thereby improving the apparatus efficiency of the perovskite cell.

In some implementations, 0<Ra₂≤1.5 nm. In this way, the flatness and smoothness of the film surface of the perovskite layer are higher, and the device efficiency of the perovskite cell is also higher.

In some implementations, a quantity of pinholes per unit area of the perovskite layer is n₂, and 0 ≤ n₂ ≤ 2. Optionally, 0≤n₂≤1.

The quantity of pinholes per unit area of the perovskite layer falls within the foregoing range, helping to improve compactness of the perovskite layer, reduce a leakage current, reduce a contact gap between the hole transport layer and an interface of a charge transport layer (the hole transport layer or the electron transport layer) disposed adjacent to the hole transport layer, improve carrier transport efficiency, and further improve the apparatus efficiency of the perovskite cell.

In some implementations, a mean surface potential difference of the perovskite layer satisfies: -10V≤Raw Mean≤10V. For example, Raw Mean may be -10V, -9V, -8V, -7V, -6V, -5V, -4V, -3V, -2V, -1V, 0V, 1V, 2V, 3V, 4V, 5V, 6V, 7V, 8V, 9V, or 10V or fall within a range formed by any values described above. In this way, the surface potential of the perovskite layer is relatively uniformly distributed, which means that the film quality of the perovskite layer is relatively high, to enable the perovskite cell to have relatively high efficiency.

In some implementations, a mean surface potential difference of the perovskite layer satisfies: -3V≤Raw Mean≤5V. In this way, the surface potential of the perovskite layer is more uniformly distributed, and the film quality of the perovskite layer is higher, to enable the perovskite cell to have higher efficiency.

In some implementations, a thickness of the perovskite layer ranges from 700 nm to 1200 nm. For example, the thickness of the perovskite layer may be 700 nm, 800 nm, 900 nm, 1000 nm, 1100 nm, or 1200 nm or fall within a range formed by any values described above. Optionally, a thickness of the perovskite layer ranges from 800 nm to 1000 nm.

The thickness of the perovskite layer falls within the foregoing range, which helps to promote carrier transport and collection, thereby promoting improvement of the apparatus efficiency of the perovskite cell.

In the present application, the surface roughness of the hole transport layer and the surface roughness of the perovskite layer have meanings well-known in the art, and may be tested using a method known in the art. For example, the surface roughness of the hole transport layer and the surface roughness of the perovskite layer may be tested by using an atomic force microscopy (AFM) representation.

In the present application, the mean surface potential difference of the perovskite layer refers to an average value of potential differences at different locations on the surface of the perovskite layer, and may reflect the potential distribution on the surface of the perovskite layer. The mean surface potential difference may be represented and tested by using Kelvin Probe Force Microscopy (KPFM). In the method, when an AFM topography of the surface of the perovskite layer is scanned, magnitude of a potential on the surface can be detected, and finally, potential distribution on the surface of the perovskite layer is reflected.

In the present application, the quantity of pinholes per unit area of the hole transport layer and the quantity of pinholes per unit area of the perovskite layer have meanings well-known in the art, and can be measured by using methods known in the art. For example, the quantity of pinholes per unit area of the hole transport layer and the quantity of pinholes per unit area of the perovskite layer may be tested by using a scanning electron microscope representation. For example, at a magnification of 30K, a region having a unit area (for example, 2.5µm × 2.5µm) of the hole transport layer or the surface of the perovskite layer is scanned, and the quantity of pinholes is counted through observation.

In the present application, the thickness of the hole transport layer and the thickness of the perovskite layer have meanings well-known in the art, and can be measured by using methods known in the art. For example, measurement may be performed by using a micrometer.

In some implementations, the perovskite layer includes ABX₃ or A₂CDX₆, where the A ion is a monocation, the B ion is a dication, the C ion is a monocation, the D ion is a trication, and the X ion is a monoanion.

In some implementations, the A ion includes one or more of an organic cation, Li⁺, Na⁺, K⁺, Rb⁺, and Cs⁺.

In some examples, the organic cation includes at least one of methylammonium, ethylammonium, propylammonium, butylammonium, pentylammonium, hexylammonium, formamidinium, and imidazolium.

In some examples, the A ion includes one or more of an organic amine ion and Cs⁺.

In some implementations, the B ion includes one or more of Pb²⁺, Sn₂⁺, Be²⁺, Mg²⁺, Ca²⁺, Sr²⁺, Ba²⁺, Zn₂⁺, Ge²⁺, Fe²⁺, Co²⁺, Cu²⁺, and Ni²⁺.

Optionally, the B ion includes one or two of Pb²⁺ and Sn₂⁺.

In some implementations, the C ion includes one or more of Cs⁺, Ag⁺, K⁺, and Ru⁺.

In some implementations, the D ion includes one or more of Bi³⁺, Ni³⁺, Fe³⁺, and Cu³⁺.

In some implementations, the X ion includes one or more of F⁻, Cl⁻, Br⁻, and I⁻.

Optionally, the X ion includes one or more of Cl⁻, Br⁻, and I⁻.

Optionally, the perovskite layer includes a compound APb_{y}Sn_{1-y}X₃, and 0<y<1.

In some examples, the perovskite cell in the present application is optionally a tin-lead perovskite cell. The perovskite layer includes the foregoing compound APb_{y}Sn_{1-y}X₃, and 0<y<1.

In some implementations, as shown in FIG. 2, the perovskite cell further includes an electron transport layer 50, and the electron transport layer 50 is disposed between the perovskite layer 40 and the second electrode layer 60.

In some implementations, as shown in FIG. 2, the perovskite cell includes a first electrode layer 20, a hole transport layer 30, a perovskite layer 40, an electron transport layer 50, and a second electrode layer 60 stacked sequentially. Further, the perovskite cell may be either of an inverted p-i-n cell and a standard n-i-p cell.

In some implementations, one of the "first electrode" and the "second electrode" is a transparent electrode, and is used for light incidence. In some implementations, the first electrode layer is a transparent electrode layer.

In some implementations, the first electrode layer includes a transparent conductive metal oxide.

In some implementations, the transparent conductive metal oxide may include, for example, but is not limited to, one or more of the following materials: fluorine-doped tin oxide (FTO), tin-doped indium oxide (ITO), aluminum-doped zinc oxide (AZO), boron-doped zinc oxide (BZO), indium zinc oxide (IZO), and tungsten-doped indium oxide (IWO).

In some examples, the transparent conductive metal oxide includes one or two of fluorine-doped tin oxide and tin-doped indium oxide.

In some examples, when the transparent electrode layer includes FTO, a thickness of a conductive region of the transparent electrode layer ranges from 400 nm to 700 nm.

In some examples, when the transparent electrode layer includes ITO, a thickness of a conductive region of the transparent electrode layer ranges from 150 nm to 250 nm.

In some implementations, the second electrode includes a conductive material. Further, the conductive material may be an organic conductive material, an inorganic conductive material, or a combination thereof. A non-limiting example of the inorganic conductive material is a metal conductive material. Further, the metal conductive material may include any one of gold (Au), silver (Ag), copper (Cu), aluminum (Al), nickel (Ni), chromium (Cr), bismuth (Bi), platinum (Pt), and magnesium (Mg), or any suitable mixture of the foregoing elements. The conductive material may include a conductive oxide. Further, the conductive material may be a conductive oxide. A non-limiting example of the conductive oxide may include one or more of FTO, ITO, IWO, AZO, and the like.

In some implementations, the perovskite cell is either of an inverted p-i-n cell and a standard n-i-p cell.

The perovskite cell provided in the present application may include a standard perovskite cell and an inverted perovskite cell.

The standard perovskite cell includes a transparent electrode as well as an electron transport layer, a perovskite layer, a hole transport layer, and a second electrode layer sequentially stacked on the transparent electrode.

The inverted perovskite cell includes a transparent electrode as well as a hole transport layer, a perovskite layer, an electron transport layer, and a second electrode layer sequentially stacked on the transparent electrode. The transparent electrode is used for light incidence.

The perovskite layer in the present application is a light-absorbing layer in the perovskite cell.

During operation of the perovskite cell, after the light-absorbing layer is irradiated, internal electrons acquire energy and break loose from the light-absorbing layer to form negatively-charged electron carriers and positively-charged hole carriers, to obtain an electron-hole pair. A free electron and a free hole are transferred in opposite directions through a corresponding transport layer, so that the electron and the hole flow to form an external current, thereby converting light energy into electric energy. Further, after absorbing a photon, the perovskite layer is excited to generate an electron-hole pair, and the electron-hole pair is further disassociated to form free carriers having opposite charges. A free electron is transferred to the positive electrode through the electron transport layer, and a free hole is transferred to the negative electrode through the hole transport layer. The two types of free carriers are respectively collected by the corresponding electrodes, and a photocurrent is further formed in the circuit of the perovskite cell.

The electron transport layer can extract and transport electron carriers, and can block free holes from passing through.

The hole transport layer can extract and transport hole carriers, and can block free electrons from passing through.

It may be understood that, in the two electrodes included in the perovskite cell, namely, the first electrode and the second electrode, one is used as a positive electrode, and may collect the electron carriers transported through the electron transport layer, and the other is used as a negative electrode, and may collect the hole carriers transported through the hole transport layer.

In some implementations, the material of the electron transport layer may include, but is not limited to, one or more of the following materials and derivatives thereof: an imide compound, a quinone compound, fullerene and a derivative thereof, methoxytriphenylamine-fluoroformamidine (OMeTPA-FA), calcium titanate (CaTiO₃), lithium fluoride (LiF), calcium fluoride (CaF₂), poly(3,4-ethylenedioxythiophene):polystyrene sulfonate (PEDOT:PSS), poly-3-hexylthiophene (P3HT), triptycene-cored triphenylamine (H101), 3,4-ethylenedioxythiophene-methoxytriphenylamine (EDOT-OMeTPA), N-(4-aniline)carbazole-spirobifluorene (CzPAF-SBF), polythiophene, a first metal oxide, silicon oxide (SiO₂), strontium titanate (SrTiO₃), cuprous thiocyanate (CuSCN), and the like. The metal element in the first metal oxide may include one or more of magnesium (Mg), nickel (Ni), cadmium (Cd), zinc (Zn), indium (In), lead (Pb), molybdenum (Mo), tungsten (W), antimony (Sb), bismuth (Bi), copper (Cu), mercury (Hg), titanium (Ti), silver (Ag), manganese (Mn), iron (Fe), vanadium (V), tin (Sn), zirconium (Cr), strontium (Sr), gallium (Ga), and chromium (Cr).

In some implementations, the hole transport layer may include, but is not limited to, one or more of the following materials and derivatives thereof: materials that can transport a hole and block an electron, such as 2,2',7,7'-Tetrakis[N,N-bis(4-methoxyphenyl)amino]-9,9'-spirobifluorene (Spiro-OMeTAD), poly(triaryl amine) (PTAA), nickel oxide (NiOₓ), poly(3,4-ethylenedioxythiophene):polystyrene sulfonate (PEDOT:PSS), and WO₃.

Optionally, the hole transport layer includes poly(3,4-ethylenedioxythiophene):polystyrene sulfonate.

In some implementations, the perovskite cell may further include a substrate layer.

In some implementations, as shown in FIG. 3, the perovskite cell includes the following structures disposed in sequence: a substrate layer 10 (which may be a glass substrate or a flexible substrate), a first electrode layer 20, a hole transport layer 30, a perovskite layer 40, an electron transport layer 50, and a second electrode layer 60. The flexible substrate may include one or more materials of polyethylene terephthalate, polyimide, polyethylene, polypropylene, polystyrene, polyethylene naphthalate, and the like. Optionally, the first electrode layer is a transparent electrode layer, and is used for light incidence.

In some implementations, the perovskite cell includes the following structures disposed in sequence: a substrate layer (a glass substrate or a flexible substrate), a first electrode layer, an electron transport layer, a perovskite layer, a hole transport layer, and a second electrode layer. Optionally, the first electrode is a transparent electrode, and is used for light incidence. For the definition of the flexible substrate, reference may be made to the foregoing text.

The substrate layer in this implementation or example of the present application may be, but is not limited to, a glass substrate or a flexible substrate.

In some implementations, the substrate layer is a flexible substrate layer. Further, the material of the substrate layer may be, for example, (but is not limited to) an organic polymer material. Further, the material of the substrate layer may be obtained by mixing one or more of the following materials according to different proportions: including, but not limited to, polyvinyl alcohol (PVA), polyester (PET), polyimide (PI), polyethylene naphthalate (PEN), and polydimethylsiloxane (PDMS).

In the present application, the specification of the perovskite cell is not particularly limited, and may be, but is not limited to, 300 millimeters (mm) × 300 mm.

It may be understood that the structure of the perovskite cell involved in the present application may not be limited to the foregoing listed structural layers. Another functional layer such as a buffer layer may further be introduced according to requirements. In some examples, a buffer layer having an appropriate energy level may be disposed in the perovskite cell, and may play one or more of roles in, for example, lowering an energy level barrier, promoting energy level matching, and improving carrier extraction efficiency; and passivating an interface defect state, protecting a light-absorbing layer, inhibiting water molecules and oxygen gas from oxidizing and decomposing the cell, improving photoelectric conversion efficiency, and improving stability of the perovskite cell. According to different locations of buffer layers, types of the buffer layers may include four types: a buffer layer between the hole transport layer and the positive electrode, a buffer layer between the electron transport layer and the negative electrode, a buffer layer between the hole transport layer and the absorbing layer, and a buffer layer between the electron transport layer and the absorbing layer.

In some implementations, the perovskite cell further includes a buffer layer disposed between the first electrode layer and the hole transport layer. The buffer layer can reduce surface roughness of a surface in contact with the hole transport layer, and improve binding and adhesion between the first electrode layer and the hole transport layer.

In some implementations, a thickness of the buffer layer ranges from 1 nm to 100 nm. For example, the thickness of the buffer layer may be 1 nm, 3 nm, 5 nm, 10 nm, 15 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm, or 100 nm or fall within a range formed by any values described above. Optionally, a thickness of the buffer layer ranges from 5 nm to 100 nm. In this way, surface roughness of a surface in contact with the hole transport layer is further reduced, and binding and adhesion between the first electrode layer and the hole transport layer are further improved.

In some examples, a material of the buffer layer includes one or more of a second metal oxide, silicon oxide (SiO₂), strontium titanate (SrTiO₃), calcium titanate, lithium fluoride, calcium fluoride, cuprous thiocyanate (CuSCN), and aluminum-doped zinc oxide (AZO). The metal element in the second metal oxide may include one or more of Mg, Ni, Cd, Zn, In, Pb, Mo, W, Sb, Bi, Cu, Hg, Ti, Ag, Mn, Fe, V, Sn, Zr, Sr, Ga, and Cr.

In some examples, a manner of preparing the buffer layer includes one of spin-coating, blade coating, evaporation, printing, spraying, spray pyrolysis, and slot die coating.

According to a second aspect, the present application provides a method for preparing a perovskite cell. The method is used for preparing the perovskite cell according to the first aspect of the present application, and may include the following steps:
S10: Prepare a hole transport layer on a first electrode layer, where surface roughness of the hole transport layer is Ra₁, and Ra₁≤10 nm.
S20: Prepare a perovskite layer and a second electrode layer stacked sequentially on the hole transport layer, to obtain a perovskite cell.

In the perovskite cell prepared by using the foregoing method, the surface roughness Ra₁ of the hole transport layer is ≤ 10 nm. In this way, the flatness and smoothness of the film surface of the hole transport layer are relatively high. In this way, a contact gap between the hole transport layer and an interface of the perovskite layer disposed adjacent to the hole transport layer can be reduced, and the transport efficiency of hole carriers is improved, thereby improving the apparatus efficiency of the perovskite cell.

In some implementations, surface roughness Ra₁ of the hole transport layer is <3 nm. In this way, the flatness and smoothness of the film surface of the hole transport layer are relatively high. In this way, a contact gap between the hole transport layer and an interface of the perovskite layer disposed adjacent to the hole transport layer can be reduced, and the transport efficiency of hole carriers is improved, thereby improving the apparatus efficiency of the perovskite cell.

In some implementations, step S10 may further include: preparing the hole transport layer on the first electrode layer in a first vacuum flash-evaporation manner.

It may be understood that the principle of the vacuum flash-evaporation in the present application includes a process in which a liquid is overheated in a vacuum environment and is rapidly volatilized into vapor. During the process of the vacuum flash-evaporation, the ambient pressure of the liquid drop quickly decreases, so that the entire liquid drop is in an overheated state. In this case, the flash-evaporation not only occurs on the surface of the liquid drop, but also occurs inside the liquid drop.

During preparation of a perovskite cell, in a conventional method, a hole transport layer is usually prepared in a manner of coating+ annealing. That is, a solution of a hole transport material needs to be first applied to an electrode (for example, a transparent conductive glass substrate), and then, annealing treatment is performed within a certain temperature interval, to form a film of the hole transport layer on the electrode. This process takes a long time. In addition, more crucially, when the film of the hole transport layer is annealed, the inside of the film is strained due to heat, and fine cracks or wrinkles are generated in and on the surface of the film. As a result, the surface of the film is not flat, and many pinholes are generated in the film, increasing a contact gap between the hole transport layer and an interface of the perovskite layer disposed adjacent to the hole transport layer, and reducing the apparatus efficiency of the perovskite cell.

However, in the foregoing method for preparing a perovskite cell provided in the present application, the hole transport layer is prepared in the vacuum flash-evaporation manner. Because the vacuum flash-evaporation can rapidly extract and remove the solvent in the solution of the hole transport material, the process time can be greatly shortened. More importantly, when the hole transport layer is prepared through vacuum flash-evaporation, a process of annealing treatment (whose temperature usually ranges from 100°C to 160°C) in the conventional method may be omitted, which can reduce generation of fine cracks or wrinkles in and on the surface of the film of the hole transport layer caused by the process, reduce the quantity of pinholes in the film, reduce the surface roughness of the film, and improve the surface flatness of the film, thereby reducing a contact gap between the hole transport layer and the interface of the perovskite layer, and facilitating throughout-growth of the grains in the perovskite layer and collection of the hole carriers. Therefore, improvement in the apparatus efficiency of the perovskite cell is facilitated.

In some implementations, the preparing the hole transport layer in the first vacuum flash-evaporation manner may include the following steps:
S110: Coat the first electrode layer with a solution of a hole transport material, to form a wet film of the hole transport material.
S120: Perform first vacuum flash-evaporation treatment on the wet film of the hole transport material, to flash-evaporate a solvent in the solution of the hole transport material, and form the hole transport layer.

In the foregoing step, by performing the first vacuum flash-evaporation treatment on the wet film of the hole transport material, the solvent in the solution of the hole transport material may be flash-evaporated. Even if the solvent is vaporized in an extremely short time, and the hole transport material forms a film in an extremely short time, the formed hole transport layer has relatively high surface flatness and smoothness, and cracks inside and on the surface of the film are very few, which helps to improve the apparatus efficiency of the perovskite cell.

In some implementations, the hole transport material includes one or more of 2,2',7,7'-Tetrakis[N,N-bis(4-methoxyphenyl)amino]-9,9'-spirobifluorene (Spiro-OMeTAD), poly(triaryl amine) (PTAA), poly(3,4-ethylenedioxythiophene):polystyrene sulfonate, poly[bis(4-phenyl)(2,4,6-trimethylphenyl)amine], 2,2',7,7'-Tetrakis[N,N-bis(4-methoxyphenyl)amino]-9,9'-spirobifluorene, poly-3-hexylthiophene, triptycene-cored triphenylamine, 3,4-ethylenedioxythiophene-methoxytriphenylamine, and N-(4-aniline)carbazole-spirobifluorene. Optionally, the hole transport material is poly(3,4-ethylenedioxythiophene):polystyrene sulfonate (PEDOT:PSS).

In some implementations, the first vacuum flash-evaporation treatment may be performed in an air atmosphere.

It may be understood that, the solution of the hole transport material is usually a water solution of a polymer, and especially in a tin-lead perovskite cell, a solution of the hole transport material is usually a water solution of poly(3,4-ethylenedioxythiophene):polystyrene sulfonate (PEDOT:PSS). Therefore, when the first vacuum flash-evaporation treatment is performed, impurities such as water and oxygen in the air basically do not affect the hole transport material, and the first vacuum flash-evaporation treatment may be directly performed in an air atmosphere.

In some implementations, a temperature of the first vacuum flash-evaporation treatment ranges from 15°C to 35°C. For example, the temperature of the first vacuum flash-evaporation treatment may be 15°C, 20°C, 25°C, 30°C, or 35°C or fall within a range formed by any values described above.

It may be understood that, when the first vacuum flash-evaporation treatment is performed, the temperature of the first electrode layer and the temperature of the solution of the hole transport material both fall within the foregoing range.

The temperature of the first vacuum flash-evaporation treatment falls within the foregoing range, helping to reduce generation of fine cracks or wrinkles inside and on the surface of the film of the hole transport layer, reduce the surface roughness of the film, and improve the surface flatness of the film, thereby improving the apparatus efficiency of the perovskite cell.

In some implementations, an extraction rate of the first vacuum flash-evaporation treatment ranges from 5 m³/h to 20 m³/h. For example, the extraction rate of the first vacuum flash-evaporation treatment may be 5 m³/h, 7 m³/h, 10 m³/h, 13 m³/h, 15 m³/h, 17 m³/h, or 20 m³/h or fall within a range formed by any values described above. Optionally, an extraction rate of the first vacuum flash-evaporation treatment ranges from 15 m³/h to 20 m³/h.

The extraction rate of the first vacuum flash-evaporation treatment falls within the foregoing range, helping to improve film forming quality of the hole transport layer, and further improve the apparatus efficiency of the perovskite cell.

It may be understood that the extraction rate and the extraction time of the first vacuum flash-evaporation treatment are related to the power of the first vacuum flash-evaporation treatment and a device for implementing the first vacuum flash-evaporation treatment. The power may be adjusted according to an internal capacity of the device and an actual manufacturing requirement, and therefore, the extraction rate and the extraction time may also be adaptively adjusted.

In some examples, the extraction time of the first vacuum flash-evaporation treatment ranges from 10 seconds (s) to 180s. For example, the extraction time may be 10s, 50s, 90s, 130s, 170s, or 180s or fall within a range formed by any values described above. Optionally, the extraction time ranges from 30s to 60s.

As a non-restrictive example, as shown in FIG. 4, a wet film of a hole transport material may be placed in a closed container through an opening at one end of the closed container, a vacuum pump is connected to the other end of the container through an opening, and first vacuum flash-evaporation treatment may be performed through the container and the vacuum pump. That is, air in the container and a solvent in the wet film of the hole transport material may be rapidly extracted by using the vacuum pump. In this way, the film of the hole transport layer is formed.

It may be understood that, in the perovskite cell in the present application, based on that the hole transport layer is prepared in the manner of vacuum flash-evaporation, the perovskite layer may also be prepared in the manner of vacuum flash-evaporation. That is, during preparation of the perovskite cell of the present application, only the hole transport layer may be prepared in the manner of vacuum flash-evaporation; or both the hole transport layer and the perovskite layer may be prepared in the manner of vacuum flash-evaporation.

Optionally, based on that the hole transport layer is prepared in the first vacuum flash-evaporation manner, the perovskite layer is prepared in the second vacuum flash-evaporation manner.

The preparing the perovskite layer in the vacuum flash-evaporation manner can effectively regulate the internal grain growth and the surface morphology of the perovskite layer, improve the film quality of the perovskite layer, and further improve the apparatus efficiency of the perovskite cell.

In some implementations, the preparing the perovskite layer in the second vacuum flash-evaporation manner may include the following steps:
S210: Coat the hole transport layer with a perovskite precursor solution, to form a perovskite wet film;
S220: Perform second vacuum flash-evaporation treatment on the perovskite wet film, to flash-evaporate a solvent in the perovskite precursor solution, and form a perovskite intermediate phase film.
S230: Perform annealing treatment on the perovskite intermediate phase film, to form the perovskite layer.

During preparation of a perovskite cell, in a conventional method, the perovskite layer is usually prepared by using an anti-solvent method. However, in a process of preparing a perovskite cell, particularly, in a process of preparing a tin-lead perovskite cell, an anti-solvent itself is highly toxic and pollutes the environment. In addition, due to extreme reliance on operating procedures of experimental personnel, uncontrollable human factors such as the dropping time and the dropping speed cause non-uniform crystallization quality of the perovskite film, poor apparatus repeatability, and high costs, to disfavor commercial production. This severely restricts application of the tin-lead perovskite cell.

In addition, the anti-solvent method is a preparation method of rapid crystallization. Generally, the perovskite film is formed by rapid nucleation and crystallization from a solution at a relatively low temperature. This causes the perovskite film to have a stack of many small grains, have a complex polycrystalline structure, and have a large quantity of crystal boundaries. Severe non-radiative recombination easily occurs at these crystal boundaries, to further affect carrier transport, promote ion migration, and introduce deep-level defects, thereby causing reduction of apparatus efficiency and stability of the perovskite cell. In addition, the crystallization speed of the tin-lead perovskite cell is further far higher than that of a conventional pure-lead-based perovskite cell. Therefore, the tin-lead perovskite film prepared by using the anti-solvent method has worse film quality and higher defect density, the non-radiative recombination is more severe, and the charge transport property is worse, causing a larger decrease in the apparatus efficiency and stability of the tin-lead perovskite cell. In addition, the surface of the perovskite film prepared by using the anti-solvent method is usually relatively rough, and the quantity of pinholes in the film is relatively large. Consequently, the compactness of the perovskite film is relatively poor, and a contact gap between the film and an interface of a charge transport layer (for example, the hole transport layer) adjacent to the film is increased, affecting carrier transport, and further reducing the apparatus efficiency of the perovskite cell.

However, in this implementation of the present application, the preparing the perovskite layer in the vacuum flash-evaporation manner can quickly extract the solvent in the perovskite precursor solution, reduce a nucleation and crystallization speed of the perovskite, and increase the average size of the grains in the perovskite layer; and help to promote throughout-growth of the grains along the thickness direction of the perovskite layer, improve consistency and uniformity of the grain growth, reduce stacking between the grains. In this way, the quantity of grain boundaries between the grains can be reduced, the occurrence of non-radiative recombination at the grain boundaries can be reduced, the carrier transport efficiency can be improved, the ion migration can be suppressed, and the deep-level defects can be reduced, thereby improving the apparatus efficiency and stability of the perovskite cell. Particularly, when the perovskite layer is a tin-lead perovskite layer, the nucleation and crystallization speed of the tin-lead perovskite may be reduced to a larger extent, thereby improving apparatus efficiency and stability of the tin-lead perovskite cell to a larger extent.

In addition, the vacuum flash-evaporation can rapidly extract the solvent in the perovskite precursor solution, and compared with the anti-solvent method, recombination of the solvent and the perovskite intermediate phase film may be reduced, thereby reducing the quantity of pinholes in the perovskite layer, improving the compactness of the perovskite film, reducing the surface roughness of the perovskite layer, improving the surface flatness and smoothness, improving the overall quality of the perovskite layer, reducing the contact gap between the perovskite layer and an interface of a charge transport layer (for example, the hole transport layer) adjacent to the perovskite layer, improving the carrier transport, and further improving the apparatus efficiency of the perovskite cell.

In addition, by preparing the perovskite film through vacuum flash-evaporation, the step of manually adding the anti-solvent in drops is removed, to avoid impact of the anti-solvent atmosphere on the formation of the perovskite film. Therefore, the apparatus efficiency is higher, and the process is simpler, which is suitable for application in large-scale production.

In some implementations, the second vacuum flash-evaporation treatment may be performed in an environment in which the water content and the oxygen content are both less than 0.1 parts per million (ppm).

It should be noted that, ppm refers to parts per million of the mass of water and oxygen in the mass of all gases in the environment.

It should be noted that, water, oxygen, and the like react with the perovskite intermediate phase film to affect the film forming quality of the perovskite. Therefore, each of step S210 to step S230 may be performed in the environment in which the water content and the oxygen content are both less than 0.1 ppm, for example, may be performed in a glove box with a nitrogen atmosphere.

Optionally, the second vacuum flash-evaporation treatment may be performed in a nitrogen atmosphere. In this way, the impact of water and oxygen on the film forming quality of the perovskite can be reduced, the quality of the perovskite film can be improved, and the apparatus efficiency of the perovskite cell can be further improved.

It may be understood that the perovskite film described in the present application is equivalent to the perovskite layer in the perovskite cell.

In some implementations, a temperature of the second vacuum flash-evaporation treatment ranges from 15°C to 35°C. For example, the temperature of the first vacuum flash-evaporation treatment may be 15°C, 20°C, 25°C, 30°C, or 35°C or fall within a range formed by any values described above. Optionally, a temperature of the second vacuum flash-evaporation treatment ranges from 18°C to 22°C.

The temperature of the second vacuum flash-evaporation treatment falls within the foregoing range, helping to reduce generation and stack of small grains inside the film of the perovskite layer, reduce the quantity of crystal boundaries, reduce the surface roughness of the film, and improve the surface flatness of the film, thereby improving the apparatus efficiency of the perovskite cell.

In some implementations, an extraction rate of the second vacuum flash-evaporation treatment ranges from 10 m³/h to 30 m³/h. For example, the extraction rate of the second vacuum flash-evaporation treatment may be 10 m³/h, 13 m³/h, 15 m³/h, 17 m³/h, 20 m³/h, 23 m³/h, 25 m³/h, 27 m³/h, or 30 m³/h or fall within a range formed by any values described above. Optionally, an extraction rate of the second vacuum flash-evaporation treatment ranges from 15 m³/h to 30 m³/h.

The extraction rate of the second vacuum flash-evaporation treatment falls within the foregoing range, helping to improve film forming quality of the perovskite layer, and further improve the apparatus efficiency of the perovskite cell.

It may be understood that the extraction rate and the extraction time of the second vacuum flash-evaporation treatment are related to the power of the second vacuum flash-evaporation treatment and a device for implementing the second vacuum flash-evaporation treatment. The power may be adjusted according to an internal capacity of the device and an actual manufacturing requirement, and therefore, the extraction rate and the extraction time may also be adaptively adjusted.

In some examples, the extraction time of the first vacuum flash-evaporation treatment ranges from 10s to 180s. For example, the extraction time may be 10s, 50s, 90s, 130s, 170s, or 180s or fall within a range formed by any values described above. Optionally, the extraction time ranges from 25s to 40s.

As a non-restrictive example, the foregoing steps S210 to S230 may be performed in a nitrogen glove box. As shown in FIG. 4, in a nitrogen atmosphere, a perovskite wet film may be placed in a closed container through an opening at one end of the closed container, a vacuum pump is connected to the other end of the container through an opening, and second vacuum flash-evaporation treatment may be performed through the container and the vacuum pump. That is, the nitrogen in the container and the solvent in the perovskite precursor solution may be rapidly extracted by using the vacuum pump. In this way, the perovskite intermediate phase film is formed. Then, annealing treatment is performed on the perovskite intermediate phase film, to form the perovskite layer.

In some implementations, a temperature of the annealing treatment ranges from 70°C to 130°C. For example, the temperature of the annealing treatment may be 70°C, 80°C, 90°C, 100°C, 110°C, 120°C, or 130°C or fall within a range formed by any values described above. Optionally, a temperature of the annealing treatment ranges from 100°C to 130°C.

In some implementations, an annealing time of the annealing treatment ranges from 5 min to 30 min. For example, the annealing time may be 5 min, 10 min, 15 min, 20 min, 25 min, or 30 min or fall within a range formed by any values described above. Optionally, the annealing time ranges from 10 min to 20 min.

The temperature of the annealing treatment and the annealing time fall within the foregoing ranges, helping to further improve film forming quality of the perovskite film, and further improve the apparatus efficiency of the perovskite cell.

In some implementations, the perovskite precursor solution includes a compound ABX₃ or A₂CDX₆, where the A ion is a monocation, the B ion is a dication, the C ion is a monocation, the D ion is a trication, and the X ion is a monoanion.

In some examples, the A ion includes one or more of an organic cation, Li⁺, Na⁺, K⁺, Rb⁺, and Cs⁺.

Optionally, the organic cation includes at least one of methylammonium, ethylammonium, propylammonium, butylammonium, pentylammonium, hexylammonium, formamidinium, and imidazolium.

Optionally, the A ion includes one or more of an organic amine ion and Cs⁺.

In some examples, the X ion includes one or more of F⁻, Cl⁻, Br⁻, and I⁻.

Optionally, the X ion includes one or more of Cl⁻, Br⁻, and I⁻.

In some examples, the perovskite precursor solution includes a compound APb_{y}Sn_{1-y}X₃, and 0<y<1.

In some implementations, the method may further include step S30:
S30: Prepare an electron transport layer between the perovskite layer and the second electrode layer.

In some implementations, a method for preparing the electron transport layer is not limited, and the electron transport layer may be prepared by using a common method in the art, for example, a vacuum evaporation method.

In some implementations, the method may further include step S40:
S40: Prepare a buffer layer between the first electrode layer and the hole transport layer.

In some examples, a method for preparing the buffer layer includes one of spin-coating, blade coating, evaporation, printing, spraying, spray pyrolysis, and slot die coating.

According to a third aspect, the present application provides a stack cell, including the perovskite cell according to the first aspect of the present application or a perovskite cell prepared by using the method according to the second aspect of the present application.

In some examples, the stack cell includes a silicon-calcium stack cell and a calcium-calcium stack cell.

It may be understood that in the present application, the "silicon-calcium stack cell" refers to a cell formed by connecting a silicon solar cell and a perovskite cell in series; and the "calcium-calcium stack cell" refers to a cell formed by connecting a perovskite cell and a perovskite cell in series.

According to a fourth aspect, the present application provides a photovoltaic module, including at least one of the perovskite cell according to the first aspect of the present application, a perovskite cell prepared by using the method according to the second aspect of the present application, and the stack cell according to the third aspect of the present application.

It may be understood that the photovoltaic module may include only the perovskite cell described in the first aspect of the present application, or the perovskite cell may be combined with another solar cell. For example, the perovskite cell is combined with a silicon solar cell.

According to a fifth aspect, the present application provides a power consuming apparatus, including at least one of the perovskite cell according to the first aspect of the present application, a perovskite cell prepared by using the method according to the second aspect of the present application, the stack cell according to the third aspect of the present application, and the photovoltaic module according to the fourth aspect of the present application.

In some of the examples, the foregoing perovskite cell may be used as a power generation apparatus of a power consuming apparatus. The type of the power generation apparatus may include, but is not limited to, integrated power generation. The location of the power generation apparatus may include, but is not limited to, a location such as a top or a backboard of an automobile.

Further, the power consuming apparatus may include, but is not limited to, a mobile device such as a mobile phone or a notebook computer, an electric vehicle, an electric train, a ship, a satellite, and a power generation system.

FIG. 10 shows a power consuming apparatus as an example. The power consuming apparatus is an automobile, and further may be an all-electric vehicle, a hybrid electric vehicle, a plug-in hybrid electric vehicle, or the like.

In another example, the power consuming apparatus may be a mobile phone, a tablet computer, a notebook computer, a calculator, or the like.

In another example, the power consuming apparatus may be a wearable device such as a watch.

### Examples

Some examples of the present application will be described hereinafter. The examples described below are illustrative, are merely used to explain the present application, and should not be construed as a limitation to the present application. Where techniques or conditions are not indicated in the examples, the techniques or conditions described above or in the literatures in the art or described in the product specifications are followed. The reagents or instruments for which no manufacturers are noted are all commercially available common products, or can be conventionally synthesized with commercially available products.

In the following examples, "room temperature" refers to 20°C to 30°C, and further, may be 25°C.

### Example 1

### (1) Preparation of first electrode

ITO conductive glass with a size of 5 centimeters (cm) × 5 cm is taken, and an insulation region is left after laser etching. After ultrasonic treatment is performed by sequentially using deionized water, dishwashing liquid, ethanol, isopropoanol, acetone, ethanol, and deionized water for 20 min, drying is performed with N₂, and ultraviolet ozone cleaning treatment is performed for 15 minutes, to serve as preparation for the first electrode (a thickness of a conductive region is 200 nm).

### (2) Preparation of hole transport layer

① A PEDOT:PSS water solution (whose mass concentration is 1.7 weight percent (wt%)) is prepared, 2 milliliters (mL) of the water solution are taken, and the water solution is filtered through a filter with a pore size of 0.45 micrometer (µm). the buffer layer in step (1) is spin-coated with 200 microliters (µL) of the filtered water solution for a spin-coating time of 30 seconds at 4000 revolutions per minute (rpm/min) through a single-step spin-coating method.
② After the spin-coating is completed, the conductive glass coated with PEDOT:PSS is placed in the closed container in FIG. (4) (the model of the vacuum pump is rv12), and the surface moisture is extracted in a vacuum flash-evaporation manner to prepare the hole transport layer whose thickness is approximately 14 nm. The temperature of the vacuum flash-evaporation is 25°C, the power is 600 watts (W), the extraction rate is 60 grams/hour (g/h), and the extraction time is 60s.

### (3) Preparation of perovskite layer

① Formamidine iodide, methylamine iodide, lead iodide, stannous iodide, and stannous fluoride are mixed at a molar ratio of 0.7:0.3:0.4:0.6:0.05, and then are dissolved in N,N-dimethylformamide and dimethyl sulfoxide solvent at a volume ratio of 2:1, to obtain a perovskite precursor solution (having a molar concentration of 1.8 moles/liter (mol/L)).
② The hole transport layer obtained in step (2) is put into a nitrogen glove box, and the water content and the oxygen content in the glove box are controlled to be less than 0.1 ppm. 100 µL of the perovskite precursor solution is transferred by using a pipette to the hole transport layer in drops, and the perovskite wet film is prepared at a spin-coating speed of 4000 rpm/min for a spin-coating time of 30s by using a single-step spin-coating method.
③ The closed container in FIG. (4) is put into a nitrogen glove box, the prepared perovskite wet film is put into the closed container, and the surplus solvent is extracted in a vacuum flash-evaporation manner, to obtain the perovskite intermediate phase film. The temperature of the vacuum flash-evaporation is 25°C, the power is 600 W, the extraction rate is 70 g/h, and the extraction time is 30s.
④ The perovskite intermediate phase film is placed on a heating stage whose temperature is 100°C and is subject to annealing treatment for 10 min, to prepare a perovskite layer (whose composition is FA_{0.7}MA_{0.3}Pb_{0.4}Sn_{0.6}I₃), whose thickness is approximately 900 nm.
(4) Preparation of electron transport layer

The prepared perovskite layer is placed in a vacuum thermal evaporation device, which is vacuumized to 4×10⁻⁴ pascal (Pa), followed by deposition with 25 nm C₆₀ and 6 nm BCP (bathocuproine), to obtain the electron transport layer.

### (5) Preparation of second electrode

By using a thermal evaporation method and by using a mask having a particular pattern, a Cu counter electrode is deposited on the electron transport layer, to form the second electrode having a thickness of approximately 100 nm, and obtain the perovskite cell.

### Example 2 to Example 21

A method for preparing a perovskite cell is similar to that in Example 1, and a difference lies in that, the pertinent parameters of the perovskite and a process of preparing the same are adjusted. For details of specific parameters, refer to the following Table 1 to Table 2. "/" indicates that no corresponding parameter exists, and Raw Mean is a mean surface potential difference of the perovskite layer.

### Example 22

A method for preparing a perovskite cell is similar to that in Example 1, and a difference lies in that, in step (1), the first electrode (the thickness of the conductive region is 500 nm) is prepared by replacing the ITO conductive glass in Example 1 with FTO conductive glass.

### Example 23

A method for preparing a perovskite cell is similar to that in Example 1, and a difference lies in that, in step (1), the first electrode (the thickness of the conductive region is 500 nm) is prepared by replacing the ITO conductive glass in Example 1 with FTO conductive glass, and then an Al₂O₃ buffer layer having a thickness of 5 nm is deposited on the cleaned FTO conductive glass by using an Atomic Layer Deposition (ALD) device.

### Comparative Example 1

A method for preparing a perovskite cell is similar to that in Example 1, and a difference lies in that, the vacuum flash-evaporation method in step (2)- ② is replaced with annealing treatment (an annealing temperature is 150°C, and an annealing time is 10 min) to prepare the hole transport layer.

### Comparative Example 2

A method for preparing a perovskite cell is similar to that in Example 1, and a difference lies in that, the vacuum flash-evaporation method in step (2)- ② is replaced with annealing treatment (an annealing temperature is 150°C, and an annealing time is 10 min) to prepare the hole transport layer; and the vacuum flash-evaporation method in step (3) is replaced with the anti-solvent method to prepare the perovskite intermediate phase film. A specific preparation process is as follows:

The hole transport layer obtained in step (2) is put into a nitrogen glove box, and the water content and the oxygen content in the glove box are controlled to be less than 0.1 ppm. 100 µL of the perovskite precursor solution is transferred by using a pipette to the hole transport layer in drops, and the perovskite wet film is prepared by using a two-step spin-coating method: in a first step, a spin-coating speed is 2000 rpm/min, and a spin-coating time is 10s; and in a second step, a spin-coating speed is 5000 rpm/min, and a spin-coating time is 50s. 400 µL of chlorobenzene is added drop-wise at 20s before the end, to obtain the perovskite intermediate phase film.

**Table 1**

| | Preparation of hole transport laver | | | | Preparation of perovskite laver | | | | |
|---|---|---|---|---|---|---|---|---|---|
| | Type of hole transport material | Preparation manner | Preparing condition | | Preparation manner | Preparing condition | | | |
| | | | Vacuum flash-evaporation temperature (°C) | Extraction rate (m³/h) | | Vacuum flash-evaporation temperature (°C) | Extraction rate (m³/h) | Annealing temperature (°C) | Annealing time (min) |
| Example 1 | PEDOT:PS S | Vacuum flash-evaporation | 25 | 15 | Vacuum flash-evaporation | 25 | 25 | 100 | 10 |
| Example 2 | PEDOT:PS S | Vacuum flash-evaporation | 15 | 15 | Vacuum flash-evaporation | 25 | 25 | 100 | 10 |
| Example 3 | PEDOT:PS S | Vacuum flash-evaporatio n | 35 | 15 | Vacuum flash-evaporation | 25 | 25 | 100 | 10 |
| Example 4 | PEDOT:PS S | Vacuum flash-evaporatio n | 5 | 15 | Vacuum flash-evaporation | 25 | 25 | 100 | 10 |
| Example 5 | PEDOT:PS S | Vacuum flash-evaporatio n | 45 | 15 | Vacuum flash-evaporation | 25 | 25 | 100 | 10 |
| Example 6 | PEDOT:PS S | Vacuum flash-evaporatio n | 25 | 5 | Vacuum flash-evaporation | 25 | 25 | 100 | 10 |
| Example 7 | PEDOT:PS S | Vacuum flash-evaporatio n | 25 | 10 | Vacuum flash-evaporation | 25 | 25 | 100 | 10 |
| Example 8 | PEDOT:PS S | Vacuum flash-evaporatio n | 25 | 20 | Vacuum flash-evaporation | 25 | 25 | 100 | 10 |
| Example 9 | PEDOT:PS S | Vacuum flash-evaporatio n | 25 | 15 | Vacuum flash-evaporation | 15 | 25 | 100 | 10 |
| Example 10 | PEDOT:PS S | Vacuum flash-evaporatio n | 25 | 15 | Vacuum flash-evaporation | 35 | 25 | 100 | 10 |
| Example 11 | PEDOT:PS S | Vacuum flash-evaporatio n | 25 | 15 | Vacuum flash-evaporation | 5 | 25 | 100 | 10 |
| Example 12 | PEDOT:PS S | Vacuum flash-evaporatio n | 25 | 5 | Vacuum flash-evaporation | 45 | 25 | 100 | 10 |
| Example 13 | PEDOT:PS S | Vacuum flash-evaporatio n | 25 | 15 | Vacuum flash-evaporation | 25 | 5 | 100 | 10 |
| Example 14 | PEDOT:PS S | Vacuum flash-evaporation | 25 | 15 | Vacuum flash-evaporation | 25 | 15 | 100 | 10 |
| Example 15 | PEDOT:PS S | Vacuum flash-evaporation | 25 | 15 | Vacuum flash-evaporation | 25 | 30 | 100 | 10 |
| Example 16 | PEDOT:PS S | Vacuum flash-evaporatio n | 25 | 15 | Vacuum flash-evaporation | 25 | 25 | 70 | 10 |
| Example 17 | PEDOT:PS S | Vacuum flash-evaporatio n | 25 | 60 | Vacuum flash-evaporation | 25 | 25 | 130 | 10 |
| Example 18 | PEDOT:PS S | Vacuum flash-evaporatio n | 25 | 15 | Vacuum flash-evaporation | 25 | 25 | 60 | 10 |
| Example 19 | PEDOT:PS S | Vacuum flash-evaporatio n | 25 | 15 | Vacuum flash-evaporation | 25 | 25 | 140 | 10 |
| Example 20 | PEDOT:PS S | Vacuum flash-evaporatio n | 25 | 15 | Vacuum flash-evaporation | 25 | 25 | 100 | 5 |
| Example 21 | PEDOT:PS S | Vacuum flash-evaporatio n | 25 | 15 | Vacuum flash-evaporation | 25 | 25 | 100 | 30 |
| Example 22 | PEDOT:PS S | Vacuum flash-evaporatio n | 25 | 15 | Vacuum flash-evaporation | 25 | 25 | 100 | 10 |
| Example 23 | PEDOT:PS S | Vacuum flash-evaporatio n | 25 | 15 | Vacuum flash-evaporation | 25 | 25 | 100 | 10 |
| Comparative Example 1 | PEDOT:PS S | Annealing treatment | / | / | Vacuum flash-evaporation | 25 | 25 | 100 | 10 |
| Comparative Example 2 | PEDOT:PS S | Annealing treatment | / | / | Anti-solvent method | / | / | 100 | 10 |

**Table 2**

| | Hole transport layer | | | Perovskite layer | | | | | | |
|---|---|---|---|---|---|---|---|---|---|---|
| | Ra₁ (nm) | n₁ (pcs) | Thickness (nm) | Composition | Ra₂ (nm) | Raw Mean (V) | n₂ (pcs) | Average size of grains (nm) | Grain distribution | Thickness (nm) |
| Example 1 | 1.3 | 0 | 14 | FA_{0.7}MA_{0.3}Pb_{0.4}Sn_{0.6}I₃ | 20.6 | 1.54 | 0 | 800 | Distributed throughout along thickness direction of perovskite layer | 900 |
| Example 2 | 1.33 | 0 | 14 | FA_{0.7}MA_{0.3}Pb_{0.4}Sn_{0.6}I₃ | 22.4 | 1.56 | 0 | 785 | Distributed throughout along thickness direction of perovskite laver | 900 |
| Example 3 | 1.31 | 0 | 14 | FA_{0.7}MA_{0.3}Pb_{0.4}Sn_{0.6}I₃ | 21.9 | 1.55 | 0 | 790 | Distributed throughout along thickness direction of perovskite layer | 900 |
| Example 4 | 1.45 | 1 | 14 | FA_{0.7}MA_{0.3}Pb_{0.4}Sn_{0.6}I₃ | 23.2 | 1.66 | 1 | 750 | Distributed throughout along thickness direction of perovskite laver | 900 |
| Example 5 | 1.5 | 2 | 14 | FA_{0.7}MA_{0.3}Pb_{0.4}Sn_{0.6}I₃ | 25.4 | 1.71 | 2 | 740 | Distributed throughout along thickness direction of perovskite layer | 900 |
| Example 6 | 1.38 | 1 | 14 | FA_{0.7}MA_{0.3}Pb_{0.4}Sn_{0.6}I₃ | 24.9 | 1.59 | 0 | 760 | Distributed throughout along thickness direction of perovskite laver | 900 |
| Example 7 | 1.31 | 0 | 14 | FA_{0.7}MA_{0.3}Pb_{0.4}Sn_{0.6}I₃ | 21.5 | 1.55 | 0 | 790 | Distributed throughout along thickness direction of perovskite layer | 900 |
| Example 8 | 1.47 | 2 | 14 | FA_{0.7}MA_{0.3}Pb_{0.4}Sn_{0.6}I₃ | 24.1 | 1.67 | 1 | 730 | Distributed throughout along thickness direction of perovskite laver | 900 |
| Example 9 | 1.32 | 0 | 14 | FA_{0.7}MA_{0.3}Pb_{0.4}Sn_{0.6}I₃ | 20.7 | 1.55 | 0 | 800 | Distributed throughout along thickness direction of perovskite layer | 900 |
| Example 10 | 1.33 | 0 | 14 | FA_{0.7}MA_{0.3}Pb_{0.4}Sn_{0.6}I₃ | 20.9 | 1.58 | 0 | 780 | Distributed throughout along thickness direction of perovskite laver | 900 |
| Example 11 | 1.5 | 1 | 14 | FA_{0.7}MA_{0.3}Pb_{0.4}Sn_{0.6}I₃ | 21.8 | 1.56 | 1 | 765 | Distributed throughout along thickness direction of perovskite laver | 900 |
| Example 12 | 1.56 | 1 | 14 | FA_{0.7}MA_{0.3}Pb_{0.4}Sn_{0.6}I₃ | 26.5 | 1.57 | 1 | 756 | Distributed throughout along thickness direction of perovskite laver | 900 |
| Example 13 | 1.33 | 0 | 14 | FA_{0.7}MA_{0.3}Pb_{0.4}Sn_{0.6}I₃ | 27.4 | 1.58 | 1 | 740 | Distributed throughout along thickness direction of perovskite laver | 900 |
| Example 14 | 1.32 | 0 | 14 | FA_{0.7}MA_{0.3}Pb_{0.4}Sn_{0.6}I₃ | 21.8 | 1.56 | 0 | 785 | Distributed throughout along thickness direction of perovskite laver | 900 |
| Example 15 | 1.32 | 0 | 14 | FA_{0.7}MA_{0.3}Pb_{0.4}Sn_{0.6}I₃ | 24.5 | 1.63 | 2 | 754 | Distributed throughout along thickness direction of perovskite layer | 900 |
| Example 16 | 1.4 | 0 | 14 | FA_{0.7}MA_{0.3}Pb_{0.4}Sn_{0.6}I₃ | 22.0 | 1.56 | 0 | 790 | Distributed throughout along thickness direction of perovskite laver | 900 |
| Example 17 | 1.5 | 2 | 14 | FA_{0.7}MA_{0.3}Pb_{0.4}Sn_{0.6}I₃ | 22.5 | 1.58 | 0 | 780 | Distributed throughout along thickness direction of perovskite layer | 900 |
| Example 18 | 1.36 | 0 | 14 | FA_{0.7}MA_{0.3}Pb_{0.4}Sn_{0.6}I₃ | 27.3 | 1.55 | 0 | 760 | Distributed throughout along thickness direction of perovskite laver | 900 |
| Example 19 | 1.54 | 2 | 14 | FA_{0.7}MA_{0.3}Pb_{0.4}Sn_{0.6}I₃ | 27.9 | 1.60 | 2 | 750 | Distributed throughout along thickness direction of perovskite layer | 900 |
| Example 20 | 1.38 | 0 | 14 | FA_{0.7}MA_{0.3}Pb_{0.4}Sn_{0.6}I₃ | 28.1 | 1.56 | 2 | 700 | Distributed throughout along thickness direction of perovskite laver | 900 |
| Example 21 | 1.39 | 0 | 14 | FA_{0.7}MA_{0.3}Pb_{0.4}Sn_{0.6}I₃ | 32.5 | 1.55 | 1 | 720 | Distributed throughout along thickness direction of perovskite layer | 900 |
| Example 22 | 9.85 | 0 | 14 | FA_{0.7}MA_{0.3}Pb_{0.4}Sn_{0.6}I₃ | 24.5 | 1.73 | 0 | 780 | Distributed throughout along thickness direction of perovskite laver | 900 |
| Example 23 | 1.35 | 0 | 14 | FA_{0.7}MA_{0.3}Pb_{0.4}Sn_{0.6}I₃ | 23.2 | 1.90 | 0 | 780 | Distributed throughout along thickness direction of perovskite laver | 900 |
| Comparative Example 1 | 3.5 | 3 | 14 | FA_{0.7}MA_{0.3}Pb_{0.4}Sn_{0.6}I₃ | 35.7 | 3.20 | 2 | 750 | Distributed throughout along thickness direction of perovskite laver | 900 |
| Comparative Example 2 | 3.85 | 4 | 14 | FA_{0.7}MA_{0.3}Pb_{0.4}Sn_{0.6}I₃ | 43.5 | 3.70 | 5 | 650 | Random stack of grains | 900 |

In addition, related performance tests are performed on the perovskite cells in Examples 1 to 23 and Comparison Examples 1 to 2, and the results are shown in Table 3.

### Test method

### (1) Surface topography test

The surface topography of the hole transport layer and the surface topography of the perovskite layer are tested by using a scanning electron microscope (the model is Hitachi, HD-2700) and an atomic force microscope (the model is Oxford instrument company, MFP-3D-Origin).

### (2) Photoelectric conversion efficiency test

At a normal temperature and a normal pressure, under standard simulated sunlight (AM 1.5G, 100 milliwatts/square centimeter (mW/cm²)) irradiation, the cell performance is tested to obtain an I-V curve (a volt-amperage characteristic curve). A short-circuit current density Jsc (in milliamperes/square centimeter (mA/cm²)), an open-circuit voltage Voc (in volt (V)), a maximum light output current Jmpp (in milliamperes (mA)), and a maximum light output voltage Vmpp (in V) can be obtained based on the I-V curve and data that is fed back by a test device (a four-channel digital source meter, Keithley 2440).

A fill factor FF in % of the cell may be calculated using the formula FF=Jsc×Voc/(Jmpp×Vmpp). The photoelectric conversion efficiency PCE in % of the cell may be calculated using the formula PCE=Jsc×Voc×FF/Pw, where Pw represents input power in milliwatt (mW).

"Normal temperature and normal pressure" mean that the normal pressure is one atmosphere pressure at a temperature of 25°C; and the normal temperature refers to 20°C to 30°C, and further, may be 25°C.

### (3) Stability test

A condition for testing stability of the perovskite cell is: being stored in a nitrogen glove box with a constant temperature of 25°C and protected from light. A photocurrent density-voltage curve test is performed on the cell apparatus at particular time intervals, and the corresponding photoelectric conversion efficiency is normalized, to finally obtain a photovoltaic efficiency attenuation curve of the perovskite cell.

Maximum power point (MPP) tracking is used under simulated 1 sunlight irradiation, and when the efficiency of the cell decreases to 90% of the initial PCE of the cell, the test is stopped.

**Table 3**

| | Photoelectric conversion efficiency (%) | Stability (h) |
|---|---|---|
| Example 1 | 18.35 | 1550 |
| Example 2 | 18.00 | 1445 |
| Example 3 | 18.23 | 1500 |
| Example 4 | 17.80 | 1335 |
| Example 5 | 17.64 | 1247 |
| Example 6 | 17.85 | 1480 |
| Example 7 | 18.26 | 1535 |
| Example 8 | 17.45 | 1450 |
| Example 9 | 18.30 | 1500 |
| Example 10 | 18.25 | 1480 |
| Example 11 | 18.00 | 1400 |
| Example 12 | 17.50 | 1330 |
| Example 13 | 17.10 | 1415 |
| Example 14 | 18.22 | 1510 |
| Example 15 | 17.50 | 1432 |
| Example 16 | 18.22 | 1495 |
| Example 17 | 18.05 | 1460 |
| Example 18 | 17.20 | 1380 |
| Example 19 | 17.05 | 1350 |
| Example 20 | 17.00 | 1300 |
| Example 21 | 16.50 | 1280 |
| Example 22 | 18.20 | 1520 |
| Example 23 | 18.00 | 1480 |
| Comparative Example 1 | 15.25 | 1210 |
| Comparative Example 2 | 14.50 | 1080 |

In Table 3, it can be seen from a comparison between Examples 1 to 23 and the comparative examples that, in the present application, the photoelectric conversion efficiency and the stability of the perovskite cell obtained by preparing the hole transport layer or the perovskite layer by using the vacuum flash-evaporation method are significantly higher than those of the comparative examples, indicating that the photoelectric conversion efficiency and the stability of the cell can be improved by using the vacuum flash-evaporation method.

In addition, it can be seen from FIG. 5 that, in the comparative example 1 (FIG. (a)), the surface of the hole transport layer prepared through annealing treatment is very rough, and sometimes a large quantity of pores exist; but in Example 1 (FIG. (b)), the surface roughness of the hole transport layer prepared by using the vacuum flash-evaporation method is significantly reduced, and the surface of the hole transport layer is flatter.

It can be seen from FIG. 7 that, in Example 1 (FIG. (b)), the surface of the perovskite layer prepared by using the vacuum flash-evaporation method is smooth and flat, and there are no obvious pinholes and defects, thereby forming a more compact and uniform polycrystalline film; but in Comparative Example 2 (FIG. (a)), the surface of the perovskite layer prepared by using the anti-solvent is rough, and there are a large quantity of pinholes.

It can be seen from FIG. 8 and FIG. 9 that, in example 1 (FIG. 9), the grains in the perovskite layer prepared by using the vacuum flash-evaporation method are grown throughout along the thickness direction, the grains uniformly extend to several micrometers along the substrate and the vertical direction, and the inside of the perovskite layer presents a compact and dense morphology; but in Example 18 (FIG. 8), the small grains in the perovskite layer prepared by using the anti-solvent method are stacked on each other (whose size ranges from 200 nm to 400 nm), a large quantity of crystal boundaries exist, and severe non-radiative recombination easily occurs at these crystal boundaries, causing degradation of the photoelectric conversion efficiency and stability of the perovskite cell.

The technical features in the foregoing examples may be randomly combined. For simplicity of description, all possible combinations of the technical features in the foregoing examples are not described. However, it should be considered that these combinations of technical features fall within the scope recorded in the specification provided that these combinations of technical features do not have any conflict.

It should be noted that the present application is not limited to the foregoing examples. The foregoing examples are merely examples, and examples having substantially the same technical idea and the same effects within the scope of the technical solutions of the present application are all included in the technical scope of the present application. The above examples are only several implementations of the present application, which are described in detail, without limitation to the scope claimed by the present application. In addition, other examples constructed by applying various modifications conceivable to a person skilled in the art to the examples and combining some of the constituent elements of the examples without departing from the scope of the essence of the present application are also included in the scope of the present application. It should be noted that for persons of ordinary skill in the art, several variations and improvements may further be made without departing from the concept of the present application. These variations and improvements should also be deemed as falling within the scope of protection of the present application. Therefore, the scope of protection of the present application shall be subject to the appended claims, and the description and drawings can be used to interpret the content of the claims.

## Claims

1. A perovskite cell, comprising a first electrode layer, a hole transport layer, a perovskite layer, and a second electrode layer stacked sequentially, wherein surface roughness of the hole transport layer is Ra₁, and Ra₁≤10 nm.

2. The perovskite cell according to claim 1, wherein the surface roughness Ra₁ of the hole transport layer satisfies: 0<Ra₁≤2 nm.

3. The perovskite cell according to claim 1 or 2, wherein a quantity of pinholes per unit area of the hole transport layer is n₁, and 0 ≤ n₁ ≤ 2.

4. The perovskite cell according to any one of claims 1 to 3, wherein a quantity of pinholes per unit area of the hole transport layer is n₁, and 0 ≤ n₁ ≤ 1.

5. The perovskite cell according to any one of claims 1 to 4, wherein the perovskite layer comprises grains distributed throughout along a thickness direction of the perovskite layer.

6. The perovskite cell according to claim 5, wherein an average size of the grains ranges from 600 nm to 800 nm.

7. The perovskite cell according to claim 5 or 6, wherein an average size of the grains ranges from 650 nm to 750 nm.

8. The perovskite cell according to any one of claims 1 to 7, wherein surface roughness of the perovskite layer is Ra₂, and Ra₂<35 nm.

9. The perovskite cell according to any one of claims 1 to 8, wherein surface roughness of the perovskite layer is Ra₂, and 0<Ra₂≤25 nm.

10. The perovskite cell according to any one of claims 1 to 9, wherein a quantity of pinholes per unit area of the perovskite layer is n₂, and 0 ≤ n₂ ≤ 2.

11. The perovskite cell according to any one of claims 1 to 10, wherein a quantity of pinholes per unit area of the perovskite layer is n₂, and 0 ≤ n₂ ≤ 1.

12. The perovskite cell according to any one of claims 1 to 11, wherein a mean surface potential difference of the perovskite layer satisfies: -10V≤Raw Mean≤10V.

13. The perovskite cell according to any one of claims 1 to 11, wherein a mean surface potential difference of the perovskite layer satisfies: -3V≤Raw Mean≤5V.

14. The perovskite cell according to any one of claims 1 to 13, wherein one or more of the following conditions are satisfied:
(1) a thickness of the hole transport layer ranges from 10 nm to 30 nm; and
(2) a thickness of the perovskite layer ranges from 700 nm to 1200 nm.

15. The perovskite cell according to any one of claims 1 to 14, wherein one or more of the following conditions are satisfied:
(1) the perovskite layer comprises a compound ABX₃ or A₂CDX₆, wherein the A ion is a monocation, the B ion is a dication, the C ion is a monocation, the D ion is a trication, and the X ion is a monoanion; and
(2) the perovskite cell further comprises an electron transport layer, and the electron transport layer is disposed between the perovskite layer and the second electrode layer.

16. The perovskite cell according to claim 15, wherein one or more of the following conditions are satisfied:
(1) the A ion comprises one or more of an organic cation, Li⁺, Na⁺, K⁺, Rb⁺, and Cs⁺,
wherein the organic cation comprises at least one of methylammonium, ethylammonium, propylammonium, butylammonium, pentylammonium, hexylammonium, formamidinium, and imidazolium;
(2) the B ion comprises one or more of Pb²⁺, Sn₂⁺, Be²⁺, Mg²⁺, Ca²⁺, Sr²⁺, Ba²⁺, Zn₂⁺, Ge²⁺, Fe²⁺, Co²⁺, Cu²⁺, and Ni²⁺;
(3) the C ion comprises one or more of Cs⁺, Ag⁺, K⁺, and Ru⁺;
(4) the D ion comprises one or more of Bi³⁺, Ni³⁺, Fe³⁺, and Cu³⁺; and
(5) the X ion comprises one or more of F⁻, Cl⁻, Br⁻, and I⁻.

17. The perovskite cell according to claim 15 or 16, wherein one or more of the following conditions are satisfied:
(1) the A ion comprises one or more of an organic amine ion and Cs⁺;
(2) the B ion comprises one or two of Pb²⁺ and Sn₂⁺;
(3) the X ion comprises one or more of Cl⁻, Br⁻, and I⁻; and
(4) the perovskite layer comprises a compound APb_{y}Sn_{1-y}X₃, and 0<y<1.

18. The perovskite cell according to any one of claims 1 to 17, wherein the first electrode layer comprises a transparent conductive metal oxide.

19. The perovskite cell according to claim 18, wherein the transparent conductive metal oxide comprises one or more of fluorine-doped tin oxide, tin-doped indium oxide, aluminum-doped zinc oxide, boron-doped zinc oxide, indium zinc oxide, and tungsten-doped indium oxide.

20. The perovskite cell according to claim 18 or 19, wherein the transparent conductive metal oxide comprises one or two of fluorine-doped tin oxide and tin-doped indium oxide.

21. The perovskite cell according to claim 20, wherein one or two of the following conditions are satisfied:
(1) a material of the first electrode layer is fluorine-doped tin oxide, and a thickness of a conductive region of the first electrode layer ranges from 400 nm to 700 nm; and
(2) a material of the first electrode layer is tin-doped indium oxide, and a thickness of a conductive region of the first electrode layer ranges from 150 nm to 250 nm.

22. The perovskite cell according to any one of claims 1 to 21, further comprising a buffer layer disposed between the first electrode layer and the hole transport layer.

23. The perovskite cell according to claim 22, wherein a thickness of the buffer layer ranges from 1 nm to 100 nm.

24. A method for preparing a perovskite cell, comprising:
preparing a hole transport layer on a first electrode layer, wherein surface roughness of the hole transport layer is Ra₁, and Ra₁≤10 nm; and
preparing a perovskite layer and a second electrode layer stacked sequentially on the hole transport layer, to obtain a perovskite cell.

25. The method according to claim 24, wherein the preparing a hole transport layer on a first electrode layer comprises:
coating the first electrode layer with a solution of a hole transport material, to form a wet film of the hole transport material; and
performing the first vacuum flash-evaporation treatment on the wet film of the hole transport material, to flash-evaporate a solvent in the solution of the hole transport material, and form the hole transport layer.

26. The method according to claim 25, wherein one or more of the following conditions are satisfied:
(1) the first vacuum flash-evaporation treatment is performed in an air atmosphere;
(2) a temperature of the first vacuum flash-evaporation treatment ranges from 15°C to 35°C;
(3) an extraction rate of the first vacuum flash-evaporation treatment ranges from 5 m³/h to 20 m³/h; and
(4) the hole transport material comprises one or more of 2,2',7,7'-Tetrakis[N,N-bis(4-methoxyphenyl)amino]-9,9'-spirobifluorene, poly(triaryl amine), poly(3,4-ethylenedioxythiophene):polystyrene sulfonate, poly[bis(4-**phenyl)(2,4,6-trimethylphenyl)amine],** 2,2',7,7'-Tetrakis[N,N-bis(4-methoxyphenyl)amino]-9,9'-spirobifluorene, poly-3-hexylthiophene, triptycene-cored triphenylamine, 3,4-ethylenedioxythiophene-methoxytriphenylamine, and N-(4-aniline)carbazole-spirobifluorene.

27. The method according to any one of claims 24 to 26, wherein the preparing the perovskite layer comprises:
coating the hole transport layer with a perovskite precursor solution, to form a perovskite wet film;
performing second vacuum flash-evaporation treatment on the perovskite wet film, to flash-evaporate a solvent in the perovskite precursor solution, and form a perovskite intermediate phase film; and
performing annealing treatment on the perovskite intermediate phase film, to form the perovskite layer.

28. The method according to claim 27, wherein one or more of the following conditions are satisfied:
(1) the second vacuum flash-evaporation treatment is performed in a nitrogen atmosphere;
(2) a temperature of the second vacuum flash-evaporation treatment ranges from 15°C to 35°C;
(3) an extraction rate of the second vacuum flash-evaporation treatment ranges from 10 m³/h to 30 m³/h;
(4) a temperature of the annealing treatment ranges from 70°C to 130°C;
(5) an annealing time of the annealing treatment ranges from 5 min to 30 min; and
(6) the perovskite precursor solution comprises a compound ABX₃ or A₂CDX₆, wherein the A ion is a monocation, the B ion is a dication, the C ion is a monocation, the D ion is a trication, and the X ion is a monoanion; and
the A ion comprises one or more of an organic cation, Li⁺, Na⁺, K⁺, Rb⁺, and Cs⁺,
wherein the organic cation comprises at least one of methylammonium, ethylammonium, propylammonium, butylammonium, pentylammonium, hexylammonium, formamidinium, and imidazolium;
the B ion comprises one or more of Pb²⁺, Sn₂⁺, Be²⁺, Mg²⁺, Ca²⁺, Sr²⁺, Ba²⁺, Zn₂⁺, Ge²⁺, Fe²⁺, Co²⁺, Cu²⁺, and Ni²⁺;
the C ion comprises one or more of Cs⁺, Ag⁺, K⁺, and Ru⁺;
the D ion comprises one or more of Bi³⁺, Ni³⁺, Fe³⁺, and Cu³⁺; and
the X ion comprises one or more of F⁻, Cl⁻, Br⁻, and I⁻.

29. The method according to claim 28, wherein the perovskite precursor solution comprises a compound APb_{y}Sn_{1-y}X₃, and 0<y<1.

30. The method according to any one of claims 24 to 29, further comprising: preparing an electron transport layer between the perovskite layer and the second electrode layer.

31. The method according to any one of claims 24 to 30, further comprising: preparing a buffer layer between the first electrode layer and the hole transport layer.

32. A stack cell, comprising the perovskite cell according to any one of claims 1 to 23 or a perovskite cell prepared by using the method according to any one of claims 24 to 31.

33. A photovoltaic module, comprising at least one of the perovskite cell according to any one of claims 1 to 23, a perovskite cell prepared by using the method according to any one of claims 24 to 31, and the stack cell according to claim 32.

34. A power consuming apparatus, comprising at least one of the perovskite cell according to any one of claims 1 to 23, a perovskite cell prepared by using the method according to any one of claims 24 to 31, the stack cell according to claim 32, and the photovoltaic module according to claim 33.
